# EUROPÄISCHE PATENTSCHRIFT

(11) **EP 3 174 077 B1**
(45) Veröffentlichungstag und Bekanntmachung des Hinweises auf die Patenterteilung: **17.04.2019**
(21) Anmeldenummer: 16195660.2
(22) Anmeldetag: 26.10.2016
(51) Int. Cl.: H01H 3/14, G01L 1/20, F16P 3/12, H01C 10/10, G01D 5/16, H03K 17/96

(54) **TRITTMATTE ZUM ABSICHERN EINER TECHNISCHEN ANLAGE**
KICK MAT FOR SECURING A TECHNICAL INSTALLATION
TAPIS DE CONTACT DESTINÉ À PROTÉGER UNE INSTALLATION TECHNIQUE

(30) Priorität: 25.11.2015 DE 102015120369
(43) Veröffentlichungstag der Anmeldung: 31.05.2017
(73) Patentinhaber: Pilz GmbH & Co. KG, 73760 Ostfildern (DE)
(72) Erfinder: Kuczera, Matthias, 73760 Ostfildern (DE); Ibrocevic, Onedin, 73760 Ostfildern (DE)
(74) Vertreter: Witte, Weller & Partner Patentanwälte mbB

(56) Entgegenhaltungen:
- EP-A2- 0 398 844
- DE-A1- 2 138 919
- FR-A5- 2 033 446
- US-A1- 2004 253 861

## Beschreibung

Die vorliegende Erfindung betrifft eine Trittmatte zum Absichern einer technischen Anlage.

Mit steigender Automatisierung von Produktionsprozessen haben sich die Anforderungen an die zuverlässige Absicherung industrieller Produktionsanlagen stetig erhöht. Beispielsweise schreibt die Maschinenrichtlinie in der Neufassung vom 17. Mai 2006 für den europäischen Wirtschaftsraum ein einheitliches Schutzniveau zur Unfallverhütung vor, welches beim Inverkehrbringen zu berücksichtigen ist. Demnach dürfen technische Anlagen, Maschinen und Roboter nur in Verbindung mit entsprechenden Sicherheitsmaßnahmen in Betrieb genommen werden. Insbesondere zählen zu diesen Maßnahmen das Überwachen von Gefahrenbereichen einer technischen Anlage und das Überführen der technischen Anlage in einen für Personen und Gegenstände sicheren Zustand, wenn ein unberechtigter Zutritt in den Gefahrenbereich stattgefunden hat.

Zur Anwesenheitserkennung von Personen sind aus dem Stand der Technik sogenannte Tritt- oder Schaltmatten bekannt, wie beispielweise in der DE 100 46 974 B4 gezeigt. Vergleichbare Trittmatten werden auch in den Dokumenten FR 2033446 A5 und DE 2138919 A1 gezeigt. Trittmatten dieser Art bestehen regelmäßig aus zwei voneinander getrennten stromführenden Platten, die durch streifen- oder gitterförmige Trennstücke auf Abstand gehalten werden. Betritt eine Person die Trittmatte, verformen sich die Platten und Trennstücke bis es zu einem Querschluss zwischen den Platten kommt. Der Querschluss ist messtechnisch erfassbar und führt dazu, dass ein angeschlossener Sicherheitsrelaisbaustein die technische Anlage abschaltet oder ein Anlaufen dieser verhindert.

Diese einfache Sensorik hat in vielerlei Hinsicht Nachteile. Insbesondere ist die Größe der Trittmatte von der Plattengröße abhängig und somit nicht beliebig erweiterbar. Darüber hinaus ist die Sensitivität einer solchen Trittmatte nicht homogen und variiert über die Fläche. Wie in der DE 100 46 974 B4 angedeutet, weisen derartige Trittmatten regelmäßig ihre normale Sensitivität in den mittleren Bereichen auf, während in den Randbereichen eine Erkennung nur ungenau oder überhaupt nicht funktioniert. Dies hat zur Folge, dass die Trittmatten auch nicht beliebig aneinander gereiht werden können, um einen größeren Bereich zu sichern, da sich an den Übergängen zwischen den Trittmatten große Bereiche durch das Aufeinandertreffen von Randbereichen ausbilden, in denen eine zuverlässig Erkennung nicht gewährleistet werden kann.

Schließlich ermöglichen die einfachen Trittmatten in der Regel auch keine ortsauflösende Erkennung, d.h. es wird lediglich ein Betreten der Trittmatte erkannt, jedoch nicht in welchem Bereich der Trittmatte dies stattgefunden hat. Beim Überwachen größerer, komplexerer Anlagen wäre es jedoch erstrebenswert, zwischen verschiedenen Gefahrenbereichen zu unterscheiden, um ein gezieltes Ansteuern der Anlage im Gefahrenfall zu ermöglichen. Dies setzt jedoch eine verbesserte Sensorik für Trittmatten voraus.

Es ist somit eine Aufgabe der vorliegenden Erfindung, eine Trittmatte anzugeben, die die vorstehend genannten Nachteile vermeidet, d.h. eine Trittmatte, die insbesondere modular erweiterbar ist und eine zuverlässige Erkennung auch in den Randbereichen ermöglicht.

Gelöst wird diese Aufgabe durch eine Trittmatte zum Absichern einer technischen Anlage mit einem Sensor, einem starren Trägerkörper und einer Auswerteeinheit, wobei der Sensor eine aktive Sensorfläche und einen flexiblen Anschlussbereich zur elektrischen Kontaktierung der Sensorfläche aufweist, der an einem Rand der aktiven Sensorfläche ausgebildet ist, wobei der Trägerkörper eine Basis mit einer Oberseite und eine daran anschließende erste Seitenfläche aufweist, wobei die Auswerteeinheit im Inneren des Trägerkörpers unterhalb der aktiven Sensorfläche angeordnet ist und dazu ausgebildet ist, ein Ausgangssignal in Abhängigkeit der Betätigung der aktiven Sensorfläche zu erzeugen, wobei die aktive Sensorfläche die Oberseite der Basis des Trägerkörpers vollständig bedeckt, und wobei der Anschlussbereich des Sensors an der ersten Seitenfläche um 180° umgelegt und ins Innere des Trägerkörpers geführt ist.

Es ist somit eine Idee der vorliegenden Erfindung, die Sensorik und den Gehäuseaufbau einer Trittmatte voneinander zu trennen. Dies hat den Vorteil, dass die wirksame Fläche der Trittmatte von der Anordnung des Sensors auf dem Gehäuse und nicht von dem Gehäuse selbst abhängig ist. Damit ist auch der Sensor nicht vom Aufbau des Gehäuses abhängig und kann beliebig ausgestaltet sein. Vorteilhaft wird ein flexibler, taktiler Sensor verwendet, der auf dem Trägerkörper angeordnet ist, sodass die aktive Sensorfläche eine Oberfläche des Trägerkörpers im Wesentlichen vollständig bedeckt. Die aktive Sensorfläche ist die Fläche des Sensors, die berührungsempfindlich ausgebildet ist, um eine mechanische Belastung zu detektieren. Die aktive Sensorfläche wird auch als wirksame Betätigungsfläche der Trittmatte bezeichnet. An die aktive Sensorfläche schließt ein Anschlussbereich an, der ebenfalls flexibel ausgestaltet ist und sich unter die aktive Sensorfläche falten lässt. Über den Anschlussbereich ist die aktive Sensoroberfläche elektrisch kontaktierbar, während die aktive Sensorfläche selbst vorteilhaft keine weiteren elektrischen Anschlüsse aufweist.

Der Anschlussbereich ist mit der Auswerteeinheit verbunden, die vorteilhaft durch den umgelegten Anschlussbereich unterhalb der aktiven Sensorfläche im Inneren des Trägerkörpers angeordnet ist. Die Auswertung des Sensors und das Erzeugen eines fehlersicheren Ausgangssignals erfolgt somit vollständig innerhalb der Trittmatte. Die wirksame Fläche der Trittmatte wird somit nicht durch die Ausgestaltung der Auswerteinheit noch der elektrischen Anschlüsse beeinflusst und ist ausschließlich abhängig von der Anordnung der aktiven Sensorfläche am Trägerkörper. Vorteilhaft bedeckt die aktive Sensorfläche eine Oberseite des Trägerkörpers im Wesentlichen vollständig, wobei die Oberseite vorzugsweise eine randlos wirksame Fläche der Trittmatte bildet. Die wirksame Fläche ist beliebig erweiterbar, indem weitere Trittmatten an die Trittmatte angelegt werden, um einen Verbund aus Trittmatten zu bilden, deren Oberflächen sich zu einem vorzugsweise nahtlosen Verbund von aktiven Sensorflächen zusammenschließen.

Die Trennung von Sensor und Gehäuse hat ferner den Vorteil, dass der Trägerkörper starr und robust ausgestaltet sein kann, da der Trägerkörper selbst nicht zur Funktion des Sensors beiträgt, sondern lediglich eine Auflage für diesen bietet. Durch eine durchgängig starre und unbiegsame Ausgestaltung des Trägerkörpers kann vorteilhaft eine homogene Sensitivität über die gesamte wirksame Fläche gewährleistet werden, wodurch die Zuverlässigkeit der Erkennung erhöht wird. Darüber hinaus kann die Trittmatte aufgrund des starren Trägerkörper auch in Bereichen mit weichem oder unebenen Untergrund vorteilhaft eingesetzt werden, da diese durch den starren Trägerkörper ausgeglichen werden, ohne dass die Sensitivität der Trittmatte beeinflusst wird.

Schließlich ermöglicht der Aufbau, dass die elektrischen Komponenten, insbesondere die Auswerteeinheit und deren elektrische Kontaktierung, geschützt im Inneren des Trägerkörpers angeordnet sein können. Damit lässt sich auf einfache Weise ein Sensor mit einer hohen Schutzart, beispielsweise IP67, realisieren.

Die eingangs genannte Aufgabe ist somit vollständig gelöst.

In einer bevorzugten Ausgestaltung sind im Anschlussbereich Aussparungen vorgesehen und die erste Seitenfläche weist ein Profil mit nutenartigen Ausnahmen auf, wobei die Aussparungen in das Profil eingreifen, wenn der Anschlussbereich um die erste Seitenfläche gelegt ist. Diese Weiterbildung hat den Vorteil, dass der Anschlussbereich am Trägerkörper fixiert ist und dass eine Kraft, die auf die aktive Sensoroberfläche wirkt, am Anschlussbereich vorbei auf die Basis und den starren Trägerkörper übertragen wird und somit den umgelegten Anschlussbereich nicht belastet. So werden die im Anschlussbereich befindlichen elektrischen Strukturen besonders gut vor den Druckbelastungen geschützt, wodurch die Haltbarkeit des Sensors erhöht wird.

In einer weiteren bevorzugten Ausgestaltung ist die aktive Sensoroberfläche aus einem flexiblen Material gefertigt und der Anschlussbereich ist eine Verlängerung der aktiven Sensoroberfläche aus demselben Material. Diese Weiterbildung hat den Vorteil, dass der Anschlussbereich und die aktive Sensoroberfläche des Sensors im Wesentlichen aus demselben Material sind und somit vorzugsweise aus einem Stück gefertigt sein können. Die Herstellung des Sensors ist somit besonders einfach und kostengünstig. Ferner werden keine zusätzlichen Komponenten, wie beispielsweise elektrische Verbinder, zur Kontaktierung der aktiven Sensoroberfläche benötigt.

In einer weiteren bevorzugten Ausgestaltung weist der Sensor eine erste Schicht mit Elektroden in einer ersten Orientierung, eine zweite Schicht mit Elektroden in einer zweiten Orientierung sowie eine zwischen der ersten und zweiten Schicht liegende dritte Schicht auf. Diese Weiterbildung hat den Vorteil, dass auf einfache Weise ein Sensor mit einer Vielzahl von Sensorzellen gebildet werden kann, die einen ortsauflösenden Sensor ermöglichen. Die Sensorzellen sind in den Bereichen ausgebildet, in denen sich die Elektroden der ersten Schicht mit den Elektroden der zweiten Schicht überlappen. Eine Sensorzelle ist somit ein Schichtensystem aus zwei Elektroden und einer dazwischenliegenden Schicht, welche die elektrischen Eigenschaften einer Sensorzelle bestimmt. Die Ausgestaltung als matrixartiger Sensor hat den Vorteil, dass in einer bevorzugten Weiterbildung nicht nur eine Belastung der gesamten Trittmatte erkannt werden kann, sondern auch die Sensorzelle bestimmbar ist, an der die Belastung aufgetreten ist. Somit lässt sich die Trittmatte auch für komplexere Anwendungen einsetzen, die einer Ortsauflösung bedürfen.

In einer besonders bevorzugten Ausgestaltung sind die erste und die zweite Schicht ein flexibles Gewebe, in das die Elektroden mit leitfähigem Garn eingewebt sind. Diese Ausgestaltung hat den Vorteil, dass der Sensor besonders leicht und flexibel ausgebildet sein kann. Die stoffartige Ausbildung ermöglicht trotz zusätzlichem Trägerkörper eine geringe Bauhöhe der Trittmatte. Außerdem ermöglicht die stoffartige Flexibilität des Sensors, dass der Anschlussbereich des Sensors enganliegend um die Seitenfläche des Trägerkörpers umlegbar ist. Der umgelegte Anschlussbereich verbreitert somit im Verhältnis zu der Dimension der gesamten Trittmatte die Trittmatt nicht und erlaubt einen nahtlosen Übergang der aktiven Sensorflächen zwischen benachbarten Trittmatten.

In einer besonders bevorzugten Ausgestaltung ist die dritte Schicht aus flexiblem leitfähigem Material gebildet, welches bei lokaler Belastung seinen spezifischen elektrischen Widerstand im Ort der Belastung ändert. Durch das flexible leitfähige Material kann besonders leicht ein Sensor mit einer Ortsauflösung gebildet werden, da mit einem Material eine Vielzahl von Sensorzellen gebildet werden kann, deren elektrische Eigenschaft von einer lokalen Belastung abhängig sind. Somit müssen die einzelnen Zellen nicht als Einzelstücke gefertigt werden, sondern entstehen vorteilhaft aus dem Zusammenfügen der ersten und zweiten Schicht als Trägermaterial für die Elektroden und der dritten Schicht für die Bestimmung der elektrischen Eigenschaften einer Zelle.

In einer weiteren bevorzugten Ausgestaltung ist der Anschlussbereich in einen ersten und einen zweiten Bereich unterteilt und die Basis weist eine weitere Seitenfläche auf, wobei der erste Bereich um die erste Seitenfläche umgelegt ist und der zweite Bereich um die weitere Seitenfläche umgelegt ist. Diese Weiterbildung hat den Vorteil, dass bei einer matrixartigen Anordnung der Elektroden in Reihen und Spalten die Elektroden der Reihen in einem ersten Anschlussbereich kontaktiert werden und die Elektroden der Spalten in einem zweiten Anschlussbereich kontaktiert werden können. Auf diese Weise kann eine besonders einfache Kontaktierung der Elektroden des Sensors erfolgen. Ferner können die erste und zweite Schicht im Wesentlichen identisch ausgestaltet sein.

In einer weiteren bevorzugten Ausgestaltung sind die Elektroden der ersten Schicht in den ersten Bereich verlängert und die Elektroden der zweiten Schicht in den zweiten Bereich verlängert. Diese Ausgestaltung hat den Vorteil, dass die Kontaktierung der Elektroden in den jeweiligen Bereichen erfolgen kann und eine Zusammenführung der Elektroden der Spalten und der Reihen des matrixartigen Sensors erst innerhalb des Trägergehäuses erfolgt. Die aktive Sensoroberfläche kann somit ausschließlich aus den Elektroden gebildet werden, ohne zusätzliche Strukturen zum Zusammenfassen der Elektroden der Spalten und der Reihen. Innerhalb des Trägerkörpers kann ein Zusammenführen dann vorteilhaft über Kabelverbindung erfolgen.

In einer weiteren bevorzugten Ausgestaltung ist der Anschlussbereich nur an einer Seite der aktiven Sensoroberfläche ausgebildet und die Elektroden der ersten Schicht und der zweiten Schicht sind in den Anschlussbereich geführt. Dies stellt somit eine Alternative zu der zuvor genannten Ausgestaltung dar. Die Ausgestaltung hat den Vorteil, dass die Anschlüsse des Sensors auf einer Seite des Sensors konzentriert sind und eine Kontaktierung der Elektroden beider Schichten auf einer Seite möglich ist. Eine Verbindung zwischen der Auswerteeinheit und den Elektroden des Sensors kann somit besonders leicht an einer einzigen Stelle erfolgen, ohne dass eine zusätzliche Verkabelung im Inneren des Trägerkörpers notwendig ist.

In einer weiteren bevorzugten Ausgestaltung weist die erste Schicht Zwischenbereiche, die die Elektroden voneinander beabstanden, und weitere Leiterbahnen mit der ersten Orientierung auf, die in den Zwischenbereichen angeordnet sind und die Elektroden der zweiten Schicht kontaktieren, wobei die Elektroden der ersten Schicht und die weiteren Leiterbahnen in den Anschlussbereich geführt sind. Diese Ausgestaltung hat den Vorteil, dass die Elektroden der zweiten Schicht auf einfache Weise auch in der ersten Schicht kontaktierbar sind. Die weiteren Leiterbahnen sind ähnlich wie die Elektroden ausgebildet und in den Zwischenbereichen zwischen den Elektroden der ersten Schicht angeordnet. Die weiteren Leiterbahnen können auf gleiche Weise erstellt werden wie die Elektroden der ersten Schicht, wobei die weiteren Leiterbahnen vorzugsweise um ein Vielfaches schmaler sind als die Elektroden der ersten Schicht.

In einer weiteren vorteilhaften Ausgestaltung ist die aktive Sensorfläche größer als 0,25 m², vorzugsweise zwischen 0,25 m² und 1 m². Die Ausgestaltung hat den Vorteil, dass besonders einfach großflächige Bereiche durch Zusammenschalten mehrerer Trittmatten abgedeckt werden können.

In einer weiteren bevorzugten Ausgestaltung ist der Anschlussbereich mit einem Umlenkradius von 0,3 cm bis 1 cm um die erste Seitenfläche umgelegt. Die Ausgestaltung hat den Vorteil, dass die Trittmatte mit einer geringen Höhe ausgebildet sein kann.

In einer weiteren vorteilhaften Ausgestaltung weist die Trittmatte eine Abdeckplatte auf, auf der die aktive Sensoroberfläche angeordnet ist, wobei die Abdeckplatte lösbar auf dem Trägerkörper angeordnet ist, um einen Zugang zu der Auswerteeinheit zu ermöglichen. Die Abdeckplatte ist wie ein Deckel ausgebildet, der auf den Trägerkörper aufgesetzt ist und einen Innenraum verschließt, in dem die Auswerteeinheit und weitere elektronische Komponenten der Trittmatte angeordnet sein können. Die Ausgestaltung hat den Vorteil, dass Sensor und Trägerkörper leicht voneinander getrennt werden können, wodurch die Handhabbarkeit und die Wartung der Trittmatte vereinfacht wird.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1:: eine schematische Darstellung möglicher Anwendungsgebiete von Ausführungsbeispielen der neuen Schutzeinrichtung,
- Fig. 2:: eine perspektivische Darstellung eines Ausführungsbeispiels einer neuen Trittmatte,
- Fig. 3:: ein Ausführungsbeispiel eines Sensors einer neuen Trittmatte,
- Fig. 4:: eine schematische Darstellung eines weiteren Ausführungsbeispiels eines Sensors,
- Fig. 5:: eine explosionsartige Darstellung eines Ausführungsbeispiels einer neuen Trittmatte,
- Fig. 6:: eine Schnittzeichnung eines Ausführungsbeispiels einer neuen Trittmatte,
- Fig.7:: eine schematische Darstellung eines Ausführungsbeispiels einer Anschlussschaltung eines Sensors,
- Fig. 8:: eine schematische Darstellung eines bevorzugten Ausführungsbeispiels einer Anschlussschaltung eines Sensors, und
- Fig. 9:: ein bevorzugtes Ausführungsbeispiel einer Unterseite einer neuen Trittmatte in einer perspektivischen Darstellung.

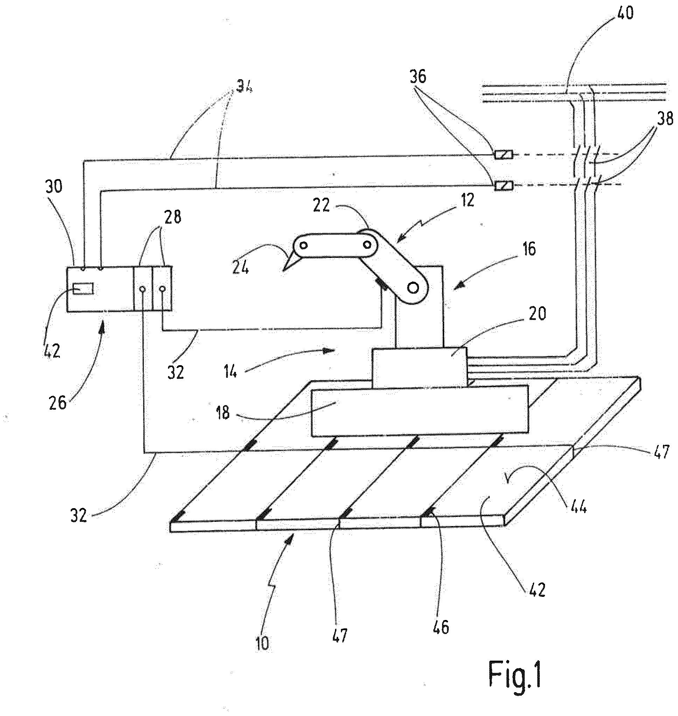

In der Fig. 1 sind ein erste druckempfindliche Schutzeinrichtung und ein zweite druckempfindliche Schutzeinrichtung in ihrer Gesamtheit mit den Bezugsziffern 10 und 12 gekennzeichnet. Die erste und zweite druckempfindliche Schutzeinrichtung dienen der Absicherung einer technischen Anlage 14, die hier als ein automatisiert arbeitender Roboter 16 angedeutet ist. Bei dem Roboter 16 kann es sich beispielsweise um einen Schneid- oder Schweißroboter in einer Fertigungs- oder Montagelinie handeln.

Der Roboter 16 ist auf einer Halterung 18 montiert und über einen Antrieb 20 um die eigene Achse drehbar. Ferner weist der Roboter 16 einen Roboterarm 22 auf, an dessen Ende sich ein Werkzeug 24 befindet. Der Dreh- und Schwenkbereich des Roboterarms 22 definiert einen Wirkungsbereich des Roboters 16, der gleichzeitig einem Gefahrenbereich des Roboters 16 entspricht. Ein Eintreten in diesen Bereich - sowohl unberechtigtes als auch berechtigtes - muss erkannt werden, sodass der Roboter in einen für Personen ungefährlichen Zustand überführt werden kann. Die Erkennung erfolgt hier durch die druckempfindlichen Schutzeinrichtungen 10 und 12, die mit einem Sicherheitssystem 26 gekoppelt sind. Das Sicherheitssystem 26 kann eine Ausgangsschalteinrichtung im Sinne der EN ISO 13856-1 sein, bspw. ein einfaches Sicherheitsschaltgerät, eine konfigurierbare Sicherheitssteuerung oder aber eine programmierbare Steuereinheit. Das Sicherheitssystem 26 ist dazu ausgebildet, die technische Anlage 14 in einem für Personen ungefährlichen Zustand zu überführen, beispielsweise indem die technische Anlage stromlos geschaltet wird.

In der Fig. 1 ist ein modulares Sicherheitssystem 26 dargestellt, welches Eingangsmodule 28 und ein Ausgangsmodul 30 aufweist. Die Eingangsmodule 28 sind über Leitungen 32 mit den druckempfindlichen Schutzeinrichtungen 10, 12 gekoppelt. Im vorliegenden Ausführungsbeispiel ist das Ausgangsmodul 30 über eine redundante Leitung 34 mit Schützen 36 verbunden, deren Arbeitskontakte 38 in einer Stromversorgung 40 des elektrischen Antriebs 20 angeordnet sind. In Abhängigkeit der an den Eingangsmodulen 28 anliegenden Signale der druckempfindlichen Schutzeinrichtungen 10, 12 steuert eine Verarbeitungseinheit 42 die Schütze 36 an, um den Roboter 16 bei Gefahr stromlos zu schalten. Es versteht sich, dass das Stromlosschalten der technischen Anlage 14 nur eine Möglichkeit darstellt, die technische Anlage in einen sicheren Zustand zu überführen. Alternativ oder ergänzend kann in einem anderen Ausführungsbeispiel das Sicherheitssystem 26 auch steuernd in den Bewegungsablauf des Roboters 16 eingreifen, um einen sicheren Zustand herzustellen, beispielsweise indem der Roboter 16 den Roboterarm 22 einzieht. Ebenso ist es denkbar, dass die Verarbeitungseinheit 42 die Signale der ersten druckempfindliche Schutzeinrichtung 10 und der zweiten druckempfindliche Schutzeinrichtung 12 oder weitere Schutzeinrichtungen kombiniert betrachtet und aus der Zusammenschau eine Entscheidung über die Ansteuerung des Roboters 16 trifft. Weitere Schutzeinrichtungen können bspw. berührungslos wirkende Schutzeinrichtungen (BWS) wie Lichtschranken oder Lichtgitter sein oder aber ein sicheres Kamerasystem.

Im Ausführungsbeispiel gemäß Fig. 1 ist die erste druckempfindliche Schutzeinrichtung 10 eine Trittmatte, insbesondere eine Schaltmatte im Sinne der EN ISO 13856-1, die auf dem Boden rund um die Halterung 18 des Roboters 16 verlegt ist. Die Trittmatte ist in diesem Ausführungsbeispiel modular aufgebaut und weist hier acht Trittmattenmodule 42 auf, die in zwei Reihen zu je vier Modulen zusammengesetzt sind. Jedes Trittmattenmodul 42 weist einen Sensor mit einer aktiven Sensorfläche 44 und einer Auswerteeinheit 46 auf. Die aktive Sensorfläche 44 ist druckempfindlich ausgebildet, wie anhand der nachfolgenden Figuren im Einzelnen noch näher erläutert wird. Die Auswerteeinheit 46 ist dazu ausgebildet, eine Belastung der druckempfindlichen aktiven Sensorfläche 44 zu registrieren und in Abhängigkeit davon ein Ausgangssignal bereitzustellen. Die Auswerteeinheit 46 kann eine digitale oder analoge Schaltung, ein Mikrocontroller, ein FPGA, ein ASIC oder eine jede andere Signalverarbeitungseinheit sein.

Das Ausgangssignal der Auswerteeinheit 46 ist in diesem Ausführungsbeispiel ein Signal, welches einen ersten Zustand und einen zweiten Zustand anzeigen kann. Vorzugsweise wird der sichere Zustand durch ein aktives Ausgangssignal (always on) angezeigt. Das Ausgangssignal ist besonders bevorzugt ein OSSD-Signal, d.h. ein redundantes Signal mit zwei Taktsignalen, die zueinander nicht synchron sind. Die Ausgangssignale der einzelnen Auswerteeinheiten 46 können einzeln oder zusammengefasst über die Leitung 32 zum Eingangsmodul 28 des Sicherheitssystems 26 übertragen werden. Bleibt das Ausgangssignal aus oder erreicht das Ausgangsignal das Eingangsmodul 28 nicht in der erwarteten Form, wird die zuvor beschriebene Sicherheitsfunktion von dem Sicherheitssystem 26 ausgeführt und die technische Anlage 14 über die Schütz 36 stromlos geschaltet.

Die aus den einzelnen Trittmattenmodulen 42 zusammengesetzte Trittmatte weist eine im Wesentlichen durchgängige Sensoroberfläche auf, die aus den einzelnen aktiven Sensorflächen 44 der Trittmattenmodule 42 gebildet ist. Im Wesentlichen durchgängig bedeutet, in diesem Zusammenhang, dass eine sicherheitsrelevante Erkennung auch in den Übergangsbereichen von benachbarten Trittmatten erfolgen kann und die passiven Randbereiche entsprechend minimiert sind. Ein Trittmattenmodul 42 weist im Ausführungsbespiel gemäß Fig. 1 einen quaderförmigen Trägerkörper mit einer ausgedehnten Basis auf. Die Basis weist eine im Verhältnis zu den Seitenflächen großflächigen Ober- und Unterseite auf. Die aktive Sensorfläche 44 der Trittmattenmodule 42 bedeckt die Oberseite der Basis vollständig. Die wirksame Betätigungsfläche des Trittmattenmoduls erstreckt sich somit nahezu über die gesamte Oberfläche des Trittmattenmoduls 42. Im Verbund mehrerer Trittmattenmodule reicht die wirksame Betätigungsfläche bis an die Stoßfugen 47 zweier benachbarter Trittmattenmodulen 42, um eine nahezu nahtlose Betätigungsfläche der Trittmatte zu bilden. In einem Ausführungsbeispiel weist der Trägerkörper zusätzlich einen schmalen Rand auf, der die Basis umläuft, um eine weitere Schutzschicht auf diesen Rand zu befestigen, um eine besonders hohe Schutzart (IP67) zu erreichen.

Zur Erkennung einer Betätigung der Trittmatte werden auch die Auswerteeinheiten 46 der einzelnen Trittmattenmodule 42 zu einem Verbund zusammengeschaltet. Dies erfolgt vorzugsweise unterhalb der aktiven Sensorflächen 44 im Inneren der Trittmattenmodule 42 oder an deren Unterseite. In einem Ausführungsbeispiel sind die Auswerteeinheiten 46 in Serie geschaltet, wobei die erste oder letzte Auswerteeinheit 46 der Kette mit dem Eingangsmodul eines Sicherheitssystems verbunden ist. Die Serienschaltung ist so ausgebildet, dass sobald ein Ausgangssignal einer Auswerteeinheit 46 ausbleibt, für die gesamte Trittmatte eine Betätigung an das angeschlossene Sicherheitssystem signalisiert wird. In anderen Ausführungsbeispielen sind aber auch andere Verknüpfungen der Auswerteeinheiten 46, bspw. ein Master- und Slave-Verbund, sowie eine andere Signalverarbeitung denkbar. So können in einem Ausführungsbeispiel auch die durch die einzelnen Auswerteeinheiten 46 erfassten Werte unmittelbar an das Sicherheitssystem weitergeleitet werden, welches selbstständig entscheidet, wie die Betätigung eines Trittmattenmoduls zu werten ist.

Im Ausführungsbeispiel gemäß Fig. 1 ist die technische Anlage 14 auf der Trittmatte und der wirksamen Oberfläche angeordnet. In anderen bevorzugten Ausführungsbeispielen ist die Trittmatte, um die Halterung 18 der technischen Anlage 14 herum angeordnet. Steht die Anlage auf der wirksamen Oberfläche, müssen die Trittmatte bzw. die einzelnen Trittmattenmodule so ausgebildet sein, dass die Bereich auf denen die technische Anlage 14 steht ausgeblendet werden können. Mit anderen Worten muss die Trittmatte ortsauflösend sein, um zu erkennen, welche Bereiche der aktiven Sensorfläche betätigt worden sind. Mittels der Ortsauflösung können dann einzelnen Bereiche, auf denen die technische Anlage 14 steht, bei der Auswertung unberücksichtigt bleiben.

Der zweite Signalgeber 12 weist in dem Ausführungsbeispiel gemäß Fig. 1 ebenfalls eine aktive Sensoroberfläche 44 sowie eine mit einem Eingangsmodul 28 des Sicherheitssystems 26 über die Leitung 32 verbundene Auswerteeinheit 46 auf. Die aktive Sensorfläche 44 des zweiten Signalgebers 12 ist hier auf einer Oberfläche der technischen Anlage 14, insbesondere auf dem Roboterarm 22 angeordnet. Die aktive Sensoroberfläche 44 ist flexibel und an die Kontur der Oberfläche der technischen Anlage 14 angepasst. Wie bei der Trittmatte können auch in diesem Ausführungsbeispiel mehrere aktive Sensorflächen 44 zu einem Verbund zusammengeschaltet werden, um die wirksame Betätigungsfläche zu vergrößern. Vorzugweise ist der im Raum bewegliche Teil des Roboters vollständig von der aktiven Sensoroberfläche 44 bedeckt.

Im Ausführungsbeispiel gemäß Fig. 1 weist der Roboterarm 22 zwei zylinderförmige Komponenten auf, auf deren zylindrischer Oberfläche die aktive Sensoroberfläche 44 angeordnet ist. Der zweite Signalgeber 12 ist im Gegensatz zum ersten Signalgeber 10 dazu ausgebildet, nicht den Zugang zur technischen Anlage 14 zu überwachen, sondern eine Berührung des Roboterarms 22 mit einem Gegenstand oder einer Person zu detektieren. Wie beim ersten Signalgeber 10 erzeugt auch die Auswerteeinheit 46 des zweiten Signalgebers ein Ausgangssignal, in dessen Abhängigkeit das Sicherheitssystem 26 den Roboter 16 steuern, insbesondere stromlos schalten kann. Der technische Aufbau des ersten und des zweiten Signalgebers 10, 12 wird anhand der nachfolgenden Figuren näher erläutert. Gleiche Bezugszeichen bezeichnen gleiche Teile.

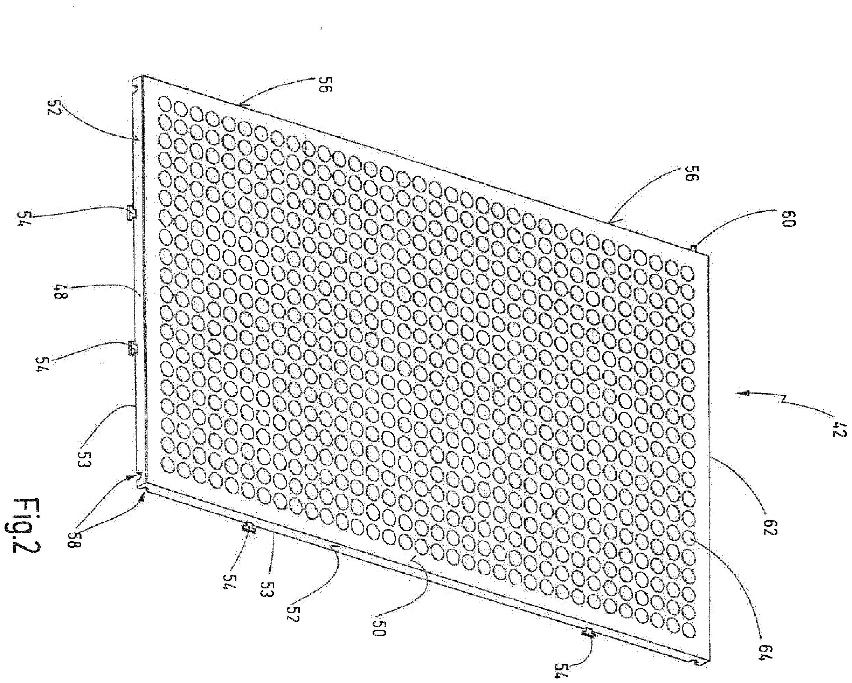

Fig. 2 zeigt eine perspektivische Darstellung eines Ausführungsbeispiels eines Trittmattenmoduls 42 der in Fig. 1 gezeigten ersten druckempfindlichen Schutzeinrichtung 10. Das Trittmattenmodul 42 weist einen starren Trägerkörper 48 mit einer großflächigen, ebenen Oberfläche 50 sowie schmalen zur Oberfläche 50 senkrecht stehenden Seitenflächen 52 auf. Im Ausführungsbeispiel gemäß Fig. 2 ist die ebene Oberfläche 50 rechteckig und das Trittmattenmodul 42 insgesamt quaderförmig ausgebildet, d.h. die Oberfläche 50, die Unterseite sowie die Seitenflächen 52 sind orthogonal zueinander angeordnet. Es versteht sich, dass in anderen Ausführungsbeispielen auch andere Formen denkbar sind. Insbesondere sind eine dreieckige, rautenförmige oder hexagonale Form der Oberfläche denkbar, also insbesondere Formen, mit denen eine Ebene lückenlose ausgefüllt (parkettiert) werden kann.

Im Ausführungsbeispiel gemäß Fig. 2 ist das Trittmattenmodul 42 60 cm breit und 1 m tief und 3 cm hoch. Vorzugsweise ist die Oberfläche 50 zwischen 0,25 m² und 1 m² groß. Dieses Maß ist besonders geeignet die Trittmattenmodule 42 wie normale Fliesen zu verlegen. Im vorliegenden Ausführungsbeispiel sind an zwei Seitenkanten 53 zu der Unterseite des Trittmattenmoduls T-förmige Verbindungselemente 54 angeordnet, die senkrecht von dem Trittmattenmodul 42 abstehen. An den zwei Seitenkanten 53 gegenüberliegenden Seitenkanten sind den Verbindungselementen 54 gegenüberliegende Aufnahmen 56 angeordnet. Die Aufnahmen 56 sind den Verbindungselementen 54 entsprechende, T-förmige Aussparungen an der Unterseite des Trägerkörpers 48, sodass zwei benachbarte Trittmattenmodule 42 bündig aneinander liegen und fixiert werden können, indem die Aufnahmen 56 und die Verbindungselemente 54 ineinandergreifen. Es versteht sich, dass in anderen Ausführungsbeispielen andere Verbindungsvorrichtungen denkbar sind. So können in einem Ausführungsbeispiel die Verbindungselemente separate Bauteile mit einer doppel-T-förmigen Kontur sein, die bei Bedarf in die Aufnahmen 56 eingelegt werden. In einem anderen Ausführungsbeispiel können auch U-Profile, bspw. aus Aluminium, zur Verbindung der Trittmattenmodule verwendet werden.

Im Ausführungsbeispiel gemäß Fig.2 sind ferner weitere Aussparungen in den Seitenflächen 52 angeordnet, wobei in mindestens einer dieser Aussparungen 58 ein Steckverbinder 60 zum elektrischen Kontaktieren eines benachbarten Trittmattenmoduls 42 angeordnet ist. In einer weiteren Aussparung 58 kann ein zum Steckverbinder 60 passender Stecker (hier nicht dargestellt) angeordnet sein. Eine Auswerteeinheit des Trittmattenmoduls 42 ist (ebenfalls hier nicht sichtbar) innerhalb des Trägerkörpers 48 angeordnet. Über die Stecker und Steckverbinder 60 kann die Auswerteeinheit mit einem Sicherheitssystem oder aber mit einer weiteren Auswerteeinheit eines benachbarten Trittmattenmoduls 42 verbunden sein. In einem Ausführungsbeispiel benötigt jede Schaltmatte einen Abschlussstecker. Vorzugsweise kann der Steckverbinder 60 in verschiedenen Aussparungen 58 angeordnet sein, wobei vorzugsweise in allen Eckbereichen des Trittmattenmoduls 42 Aussparungen 58 vorgesehen sind. Auf diese Weise kann die Trittmatte besonders leicht und flexibel zu einem Verbund zusammengesetzt werden.

Die ebene Oberfläche 50 ist in diesem Ausführungsbeispiel vollständig von einer elastischen Gummimatte 62 bedeckt, bspw. eine Matte aus Polyurethan, sodass der darunterliegende Sensor verdeckt ist. Vorzugsweise ist die Gummimatte 62 an der ebenen Oberfläche 50 und den Übergängen zu den Seitenflächen 52 so fixiert, dass Wasser, Staub und andere Verunreinigungen nicht ins Innere des Trägerkörpers 48 eindringen können. Besonders bevorzugt sind die Gummimatte 62 und der Trägerkörper 48 so ausgebildet, dass das Trittmattenmodul 42 der internationalen Schutzart IP67 genügt. Gleiches gilt für die Stecker und Steckverbinder 60. Unterhalb der Gummimatte 62, die hier an ihrer Oberfläche Noppen 64 aufweist, um die Rutschgefahr zu minimieren, sind die aktive Sensorfläche sowie die Auswerteeinheit der Trittmatte angeordnet. Die druckempfindliche aktive Sensorfläche erstreckt sich unterhalb der Gummimatte 62 über die gesamte ebene Oberfläche 50 der Basis des Trägerkörpers 48 und beschreibt den Wirkbereich des Trittmattenmoduls 42. In einem Ausführungsbeispiel erstreckt sich der Wirkbereich über die gesamte ebene Oberfläche 50 des Trägerkörpers 48. Es versteht sich, dass ein einzelnes Trittmattenmodul 42 als eigenständige Trittmatte verwendet werden kann, ohne dass es in einem Verbund verlegt werden muss.

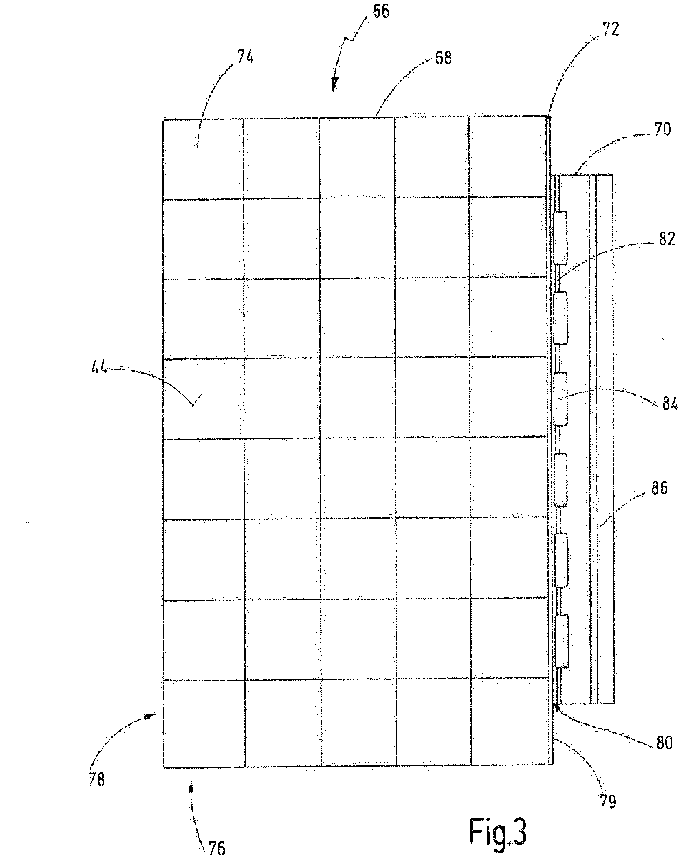

Fig. 3 zeigt ein bevorzugtes Ausführungsbeispiel eines Sensors 66 für ein Trittmattenmodul 42. Der Sensor 66 weist neben einer matrixartigen Sensoranordnung 68, welche die aktive Sensorfläche 44 bildet, einen Anschlussbereich 70 auf, über den die Sensoranordnung 68 mit einer Auswerteeinheit verbindbar ist. Die Sensoranordnung 68 und der Anschlussbereich 70 des Sensors 66 sind aus einem gemeinsamen Trägermaterial 72 gefertigt. Das Trägermaterial 72 ist vorzugsweise ein flexibles, textilartiges Gewebe, in das elektrische Strukturen eingewoben sind. Die elektrischen Strukturen in dem Gewebe entstehen durch die Verwendung von leitfähigem und nicht leitfähigem Garn. Das Trägermaterial 72 ist so flexibel, dass es sich wie eine Stoffbahn einrollen und falten lässt. Neben dem Trägermaterial 72 weist die Sensoranordnung 68 ein weiteres stoffartiges Material auf, das im Wesentlichen die druckempfindlichen Eigenschaften der Sensoranordnung 68 bestimmt.

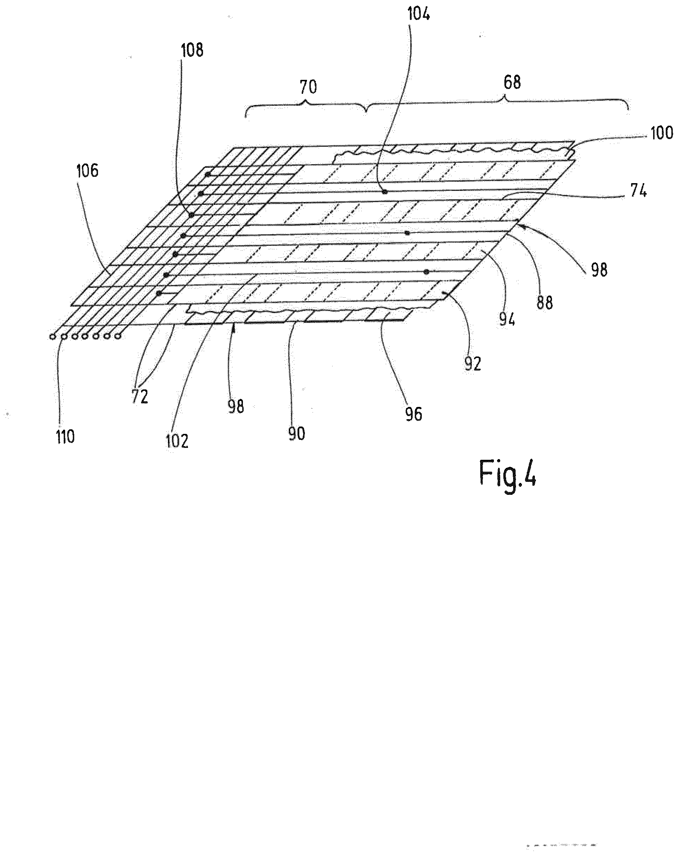

Die Sensoranordnung 68 ist aus dem Trägermaterial 72, den elektrischen Strukturen auf dem Trägermaterial 72 und dem druckempfindlichen Material gebildet. Die elektrischen Strukturen bilden einzelne Sensorzellen 74, die matrixartig in Reihen 76 und Spalten 78 angeordnet sind. Die mechanische Belastung kann für jede Sensorzelle 74 bestimmt werden, um insgesamt eine Druckverteilung über die Sensoranordnung 68 und damit insgesamt über die aktive Sensorfläche 44 zu bestimmen, wie anhand von Fig. 4 noch näher erläutert wird.

Der Anschlussbereich 70 ist in diesem Ausführungsbeispiel an einer Seitenkante 79 der Sensoranordnung 68 ausgebildet. In anderen Ausführungsbeispielen kann der Anschlussbereich 70 auch an mehreren Seitenkanten der Sensoranordnung 68 ausgebildet sein. Der Anschlussbereich 70 ist eine Verlängerung des Trägermaterials 72 und der elektrischen Strukturen darauf. Mit anderen Worten sind die Sensoranordnungen 68 und der Anschlussbereich 70 im Wesentlichen aus einem Stück gefertigt. Der Anschlussbereich 70 ist ebenfalls flexibel ausgebildet. An einer Knickkante 80, die entlang der Seitenkante 79 der Sensoranordnung 68 am Übergang zum Anschlussbereich 70 verläuft, ist der Anschlussbereich 70 faltbar. Der Anschlussbereich 70 ist dazu ausgebildet, an der Knickkante 80 umgelegt zu werden, d.h. an der Knickkante 80 kann der Anschlussbereich 70 unter die Sensoranordnung 68 gefaltet werden. In der Fig. 3 ist der Sensor nicht gefaltet dargestellt.

Der Anschlussbereich 70 kann sich über die gesamte Länge einer Seitenkante 79 der Sensoranordnung 68 erstrecken oder, wie im Ausführungsbeispiel gemäß Fig. 3, nur über einen Teilbereich der Seitenkante 79. In einem von der Seitenkante 79 ausgehenden Umlegebereich 82 weist der Anschlussbereich 70 Aussparungen 84 auf. Der Umlegebereich 82 erstreckt sich von der Knickkante 80 über dessen gesamte Länge vorzugsweise 1 bis 2 cm in den Anschlussbereich 70 hinein. Die Aussparungen 84 sind Durchgangsöffnungen im Anschlussbereich 70 und auf einer Geraden parallel zur Knickkante 80 angeordnet. Vorzugsweise sind die Aussparungen 84 rechteckige, schlitzartige Ausnahmen im Trägermaterial 72, die im Umlegebereich 82 angeordnet sind.

Der Anschlussbereich 70 weist ferner einen Kontaktierungsbereich 86 auf. Im Kontaktierungsbereich 86 können die elektrischen Strukturen kontaktiert werden, um eine elektrische Verbindung zu einer Auswerteeinheit herstellen zu können. Vorzugsweise sind im Kontaktierungsbereich 86 isolierte Kabel in das Trägermaterial 72 eingewoben, wobei an den Stellen, an denen eine Kontaktierung mit den elektrischen Strukturen erfolgen soll, die Isolierung der Kabel entfernt worden ist. Dies kann beispielsweise über nachträgliches, punktgenaues Ablasern der Isolierungen der Kabel erfolgen. Die Sensoranordnung 68 sowie deren elektrische Kontaktierung sind in der Fig. 4 näher erläutert.

Fig. 4 zeigt in einer schematischen Darstellung ein Ausführungsbeispiel einer Sensoranordnung 68 sowie dessen elektrische Kontaktierung in einem Anschlussbereich 70. Die Sensoranordnung 68 weist eine erste Schicht 88 und eine zweite Schicht 90 auf, die je aus dem Trägermaterial 72 gefertigt sind. Auf der ersten Schicht 88 und der zweiten Schicht 90 sind elektrische Strukturen, wie zuvor beschrieben, angeordnet. Die elektrischen Strukturen der ersten und zweiten Schicht 88, 90 sind aus streifenartigen Elektroden 92, 94, 96 gebildet. Die Elektroden der jeweiligen Schicht sind parallel zueinander angeordnet und durch isolierende Zwischenbereiche 98 voneinander beabstandet. Vorzugsweise sind die erste Schicht 88 und die zweite Schicht 90 aus einem Stück gefertigt, das nach der Fertigung in zwei Teile geteilt worden ist, wobei die beiden Teile um 90° verdreht zueinander übereinandergelegt worden sind, um die matrixartige Sensoranordnung 68 zu bilden.

Zwischen der ersten Schicht 88 und der zweiten Schicht 90 ist eine weitere Schicht 100 aus druckempfindlichem Material angeordnet. Vorzugsweise ist die weitere Schicht 100 aus nicht gewobenem, leitfähigem Stoff. Besonders bevorzugt ist die weitere Schicht 100 ein nicht gewobenes Mikrofasertuch, welches mit einer leitfähigen Beschichtung überzogen ist. Das druckempfindliche Material der weiteren Schicht 100 ist so ausgebildet, dass es bei mechanischer Belastung die elektrischen Eigenschaften zwischen zwei sich gegenüberliegenden Elektroden verändert.

Die Sensorzellen 74 der Sensoranordnung 68 sind in den Überlappungsbereichen (hier gestrichelt dargestellt) der Elektroden 92, 94 der ersten Schicht 88 und den Elektroden 96 der zweiten Schicht 90 ausgebildet. Es versteht sich, dass die weiteren Elektroden der ersten und zweiten Schicht weitere Sensorzellen 74 ausbilden. Jede Sensorzelle 74 ist somit über eine Elektrode der ersten Schicht 88 und eine Elektrode der zweiten Schicht 90 kontaktierbar. Zwischen den Elektroden einer Sensorzelle 74 ist das druckempfindliche Material der weiteren Schicht 100 angeordnet, welches die elektrischen Eigenschaften der Sensorzelle 74 bei einer mechanischen Belastung bestimmt. Die elektrische Eigenschaft einer Sensorzelle 74 bestimmt sich vorzugsweise über den spezifischen elektrischen Widerstand der Sensorzelle 74, der über die Elektroden der Sensorzelle 74 gemessen werden kann. Eine Änderung des spezifischen elektrischen Widerstands aufgrund einer mechanischen Belastung der Sensorzelle 74 kann sich auf vielfältige Weise ergeben. So ändert sich in einem Ausführungsbeispiel bei mechanischer Belastung der weiteren Schicht deren spezifischer elektrischer Widerstand im Ort der Belastung. In einem anderen bevorzugten Ausführungsbeispiel ergibt sich die Widerstandsänderung unter Krafteinwirkung aufgrund einer Änderung der Kontaktfläche von den Elektroden der ersten und zweiten Schicht 88, 90 zum leitfähigen Material der weiteren Schicht 100. Bspw. passen sich die erste und zweite Schicht mit den Elektroden 92, 94, 96 bei Belastung dem rauen, leitfähigen Material der weiteren Schicht 100 an, wodurch die Kontaktfläche größer wird und der Widerstand kleiner. Alternativ kann sich eine Widerstandsänderung auch aus einer durch mechanische Belastung resultierender Geometrieänderung des leitfähigen Materials der weiteren Schicht 100 ergeben.

In einem weiteren Ausführungsbeispiel ist das druckempfindliche Material ein elektrisch nicht-leitfähiges flexibles Material, das siebförmig ausgebildet ist und sich unter mechanischer Belastung verformt, sodass sich die erste und zweite Elektrode der ersten Schicht mit der dritten Elektrode in der zweiten Schicht im Bereich der mechanischen Belastung partiell berühren können. Der elektrische Widerstand einer Sensorzelle ist dann abhängig von der Elastizität, der Größe und Form des siebförmigen Gitters. Der elektrische Widerstand einer Sensorzelle bestimmt sich dann aus der Anzahl der Berührungen der durch das druckempfindliche Material beabstandeten Elektroden. Je mehr Berührungspunkte durch das mechanische Belasten des druckempfindlichen Materials im Bereich einer Sensorzelle entstehen, desto geringer ist der elektrische Widerstand der Sensorzelle.

Die Kontaktierung der Elektroden 92, 94 der ersten Schicht 88 und der Elektroden 96 der zweiten Schicht 90 erfolgt vorzugsweise an einer Seite der Sensoranordnung 68. Wie zuvor beschrieben, erfolgt die Kontaktierung in einem Anschlussbereich 70, der aus einer Verlängerung des Trägermaterials 72 der ersten und/oder der zweiten Schicht gebildet ist. Im Ausführungsbeispiel gemäß Fig. 4 sind sowohl das Trägermaterial 72 der ersten Schicht 88 als auch der zweiten Schicht 90 in den Anschlussbereich 70 verlängert. Allerdings sind hier nur die Elektroden der ersten Schicht 88 in den Anschlussbereich 70 verlängert sowie weitere Leiterbahnen 102, die in den Zwischenbereichen 98 der ersten Schicht 88 parallel zu den Elektroden angeordnet sind. Die Leiterbahnen 102 sind wie die Elektroden 92, 94 in das Trägermaterial 72 eingewoben. Die Leiterbahnen 102 können sich wie die Elektroden 92, 94 über die ganze Breite der ersten Schicht 88 erstrecken. Ferner weist die Sensoranordnung 68 Durchkontaktierungen 104 auf, die die weiteren Leiterbahnen 102 mit den Elektroden 96 der zweiten Schicht 90 elektrisch verbinden. Die Durchkontaktierungen 104 sind wie die Elektroden aus leitfähigem Garn, jedoch orthogonal zu der ersten und zweiten Schicht von der ersten Schicht 88 durch die weitere Schicht 100 in die zweite Schicht 90 geführt.

Im Anschlussbereich 70 sind isolierte Kabel 106 angeordnet, die senkrecht zu den Elektroden 92, 94 der ersten Schicht 88 sowie den weiteren Leiterbahnen 102 verlaufen. In einzelnen Kontaktpunkten 108 ist die Isolierung der Kabel 106 entfernt, sodass an diesen Stellen eine elektrische Verbindung zwischen den Elektroden 92, 94 der ersten Schicht oder einer der weiteren Leiterbahnen 102 mit den isolierten Kabeln 106 erfolgen kann. Die isolierten Kabel 106 sind an einer Seite des Anschlussbereichs 70 aus dem Trägermaterial 72 herausgeführt und mit Anschlüssen 110, beispielsweise in Form einer Steckerleiste, versehen. Über die Anschlüsse 110 können die isolierten Kabel 106 und somit die Elektroden 92, 94, 96 der ersten und zweiten Schicht 88, 90 mit einer (hier nicht dargestellten) Auswerteeinheit, die die Widerstände innerhalb der Sensorzellen 74 bestimmen kann, verbunden werden.

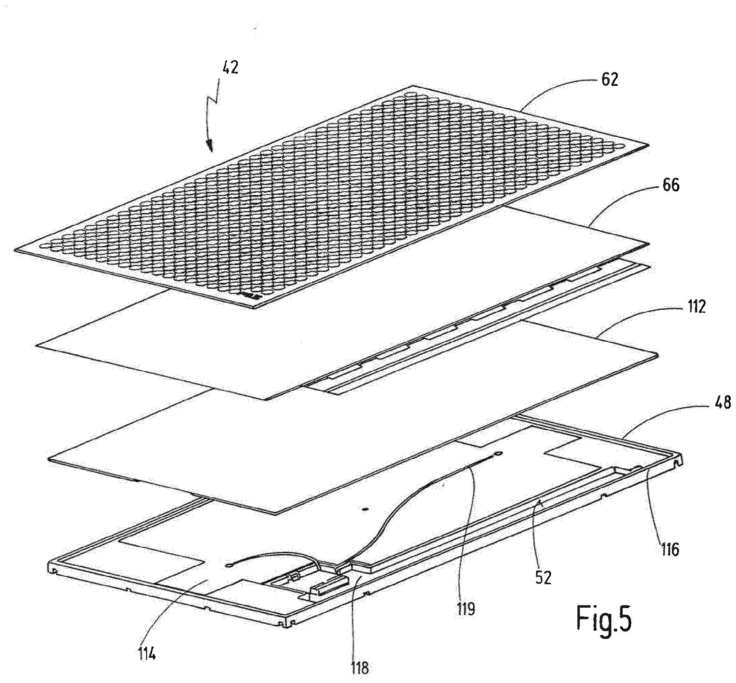

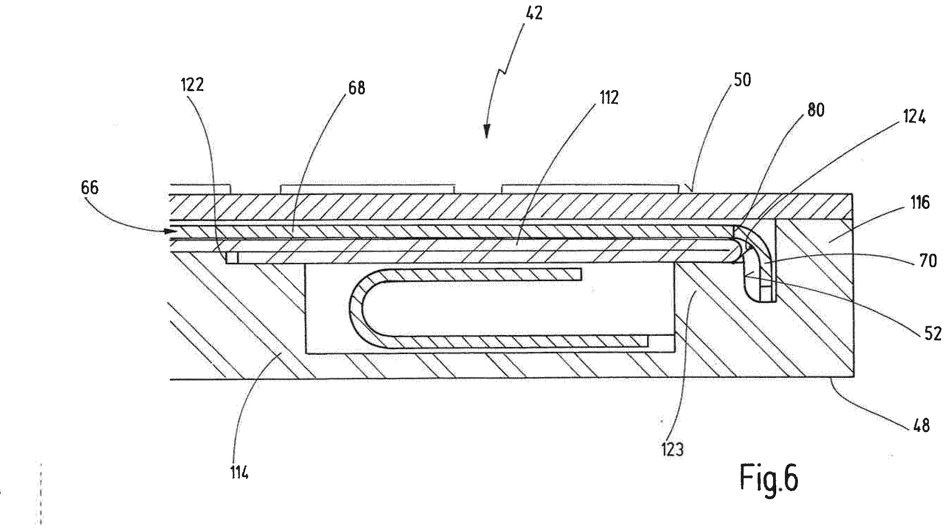

Die Fig. 5 und 6 zeigen in einer Explosionsdarstellung sowie einer Schnittzeichnung den Zusammenbau eines bevorzugten Ausführungsbeispiels eines Trittmattenmoduls 42. Gleiche Bezugszeichen bezeichnen auch hier wieder gleiche Teile.

Fig. 5 zeigt die schichtartige Zusammensetzung des Trittmattenmoduls 42. Die erste Ebene bildet die rutschfeste Gummimatte 62, unterhalb derer der Sensor 66 angeordnet ist. Dieser wiederum liegt auf einer Abdeckplatte 112 auf, die so ausgebildet ist, dass sie in den Trägerkörper 48 eingelegt werden kann. Die Abdeckplatte 112 ist so dimensioniert, dass sie von der Sensoranordnung 68 des Sensors 66 vollständig bedeckt wird, während der Anschlussbereich 70 des Sensors 66 über die Abdeckplatte 112 hinausgeht. Ebenso geht der Anschlussbereich 70 über die Gummimatte 62 hinaus. Im zusammengesetzten Zustand bilden somit die Gummimatte 62, die Abdeckplatte 112 und die Sensoranordnung 68 einen Schichtenverbund, aus dem der Anschlussbereich 70 hervorsteht.

In diesem bevorzugten Ausführungsbeispiel weist der Trägerkörper 48 eine Basis 114 mit einem umlaufenden, vorstehenden Rand 116 auf. Die Abdeckplatte 112 und die Sensoranordnung 68 liegen auf dem Trägerkörper auf. Die Fixierung der Abdeckplatte 112 auf dem Trägerkörper 48 erfolgt kraftschlüssig bzw. stoffschlüssig über mehrere Klebestellen, deren Durchmesser und Tiefe als Bohrung in dem Trägerkörper so gewählt sind, dass einerseits unterschiedliche Wärmedehnungen ausgeglichen werden und andererseits die Zugkräfte der Klebeschicht bei Temperaturänderung nicht zu einem Verzug der Trittmatte führen. In einem anderen Ausführungsbeispiel kann die Abdeckplatte 112 auch durch einen Formschluss mit dem Rand 116 fixiert sein. Ferner kann die Abdeckplatte 112 einen oder mehrere Einpressbolzen und der Trägerkörper 48 entsprechende Bohrungen aufweisen, um die Abdeckplatte 112 in Bezug zum Trägerkörper 48 zu orientieren.

Die Gummimatte 62 geht über die Abdeckplatte 112 und die Sensoranordnung 68 soweit hinaus, dass durch die Gummimatte 62 auch die Oberseite des Rands 116 bedeckt ist. Die Abdeckplatte 112 und die Sensoranordnung 68 sind auf diese Weise innerhalb des Trägerkörpers 48, vorzugsweise wasser- und staubdicht, verschlossen, indem die Gummimatte 62 auf der Oberseite des Rands 116 verklebt ist. In die Basis 114 sind Strukturen 118 in Form von Ausnahmen eingearbeitet, in denen die Elektronik des Trittmattenmoduls 42, beispielsweise die Auswerteeinheit, angeordnet sein können. Die Strukturen 118 können weiterhin Aussparungen für Kabelstränge 119 aufweisen, um die Elektronik nach außen hin zu verbinden.

Fig. 6 zeigt einen Schnitt durch ein Trittmattenmodul 42 quer zu einer Knickkante 80 des Sensors 66. Die Sensoranordnung 68 liegt auf einer Abdeckplatte 112 auf, die wiederum auf dem Trägerkörper 48 aufliegt. Die Abdeckplatte 112 kann eine starres Blech sein, welches in diesem Ausführungsbeispiel an einem Seitenrand um 180° gefaltet ist, wobei der gefaltet Abschnitt in eine Falz im Trägerkörper 48 formschlüssig eingreift, um das Blech auf dem Trägerkörper zu fixieren. Der Anschlussbereich 70 ist um eine zur Oberfläche 50 senkrecht stehende Seitenfläche 52 in einem Umlenkradius 124 umgelegt. Der Umlenkradius 124 beträgt vorzugsweise zwischen 0,2 cm und 1 cm. Beim Umlegen wird ein Vorsprung 123 des Trägerkörpers 48 durch die Aussparung 84 im Anschlussbereich geführt, auf dem die Abdeckplatte 112 aufliegt. Eine Kraft, die senkrecht auf die Oberfläche 50 einwirkt, wirkt somit nicht auf den Anschlussbereich 70, sondern wird über den Vorsprung 123 am Anschlussbereich 70 vorbei auf den Trägerkörper 48 übertragen. Der Anschlussbereich 70 ist somit beim Auftreten einer Person unbelastet.

In dem bevorzugten Ausführungsbeispiel nach Fig. 6 weist der Trägerkörper 48 zusätzlich einen Rand 116 auf, der den Trägerkörper umläuft. Auf den Rand 116 ist die rutschfeste Gummimatte 62 aufgelegt, wodurch das Innere des Trägerkörpers 48 verschlossen ist. In einem anderen Ausführungsbeispiel können die Sensoranordnung 68 und die Abdeckplatte 112 auch bis über den Rand geführt werden, sodass der Anschlussbereich 70 um den Rand 116 umgelegt und ins Innere des Trägerkörpers 48 geführt ist. Der Rand 116 weist in diesem Fall ein nutenartiges Profil auf, in das die Aussparungen 84 des Anschlussbereichs 70 eingreifen können, sodass auch hier eine auf die Oberfläche 50 einwirkende Kraft um den Anschlussbereich 70 herumgeführt wird.

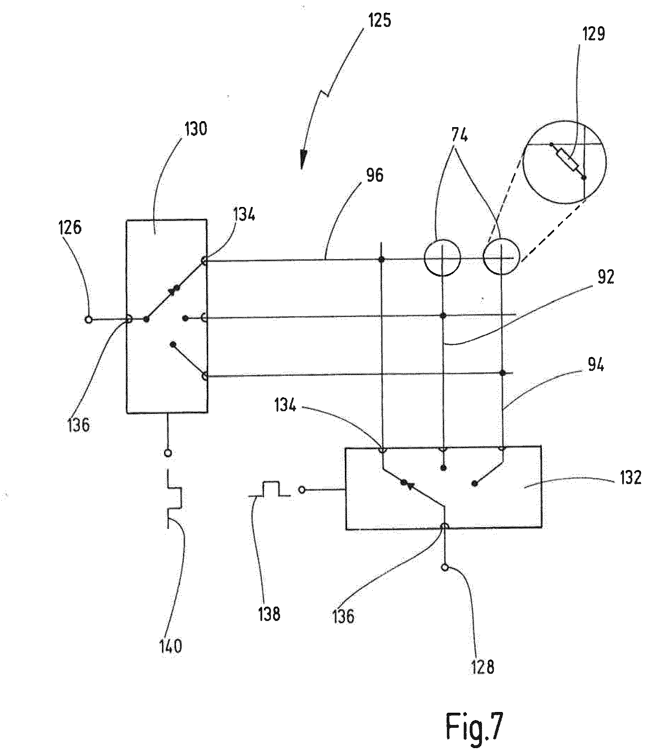

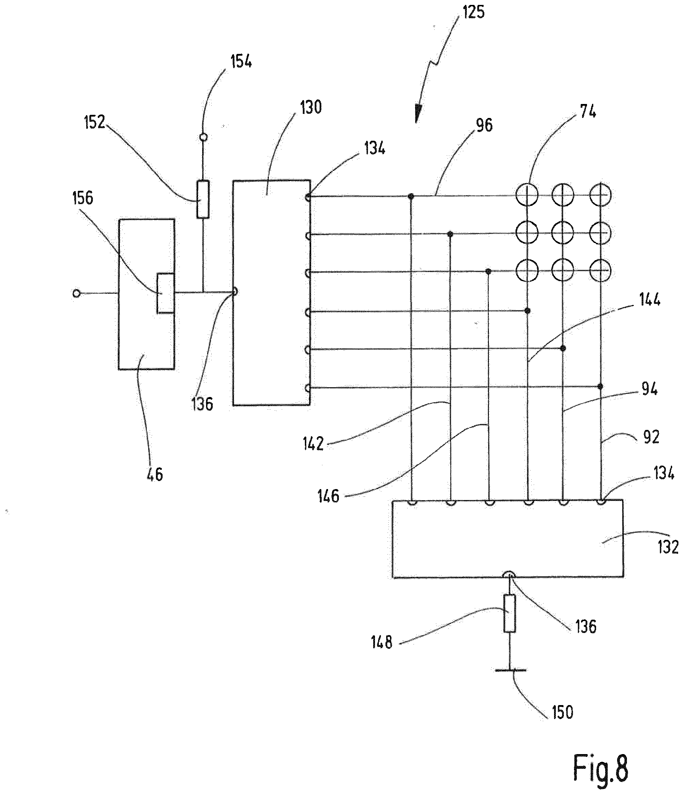

Fig. 7 und 8 zeigen zwei Ausführungsbeispiele zur Kontaktierung des Sensors 66 eines Signalgebers 10, 12 in einer schematischen Darstellung.

Fig. 7 zeigt eine erste und zweite Sensorzelle 74, die über eine Schaltungsanordnung 125 mit einem ersten Anschluss 126 und einem zweiten Anschluss 128 mit einer hier nicht näher dargestellten Auswerteeinheit verbindbar sind. Die Sensorzellen 74 sind aus einer ersten Elektrode 92, einer zweiten Elektrode 94 und einer dritten Elektrode 96 gebildet. Zwischen den Elektroden einer Sensorzelle 74 ist ein Widerstand 129 bestimmbar, der wie zuvor erläutert von der mechanischen Belastung der Sensorzelle 74 abhängig ist.

Die Elektroden 92, 94, 96 sind mit einem ersten Sequentialisierungselement 130 und einem zweiten Sequentialisierungselement 132 verbunden. Das erste und das zweite Sequentialisierungselement 130, 132 sind dazu ausgebildet, eine Vielzahl von Anschlüssen an einen Anschluss 126, 128 zusammenzuführen. Die Sequentialisierungselemente 130, 132 sind vorzugsweise als Drehschalter, sogenannte Multiplexer, ausgebildet. Ein Sequentialisierungselement 130, 132 weist eine Vielzahl von Eingängen 134 sowie einen Ausgang 136 auf. Bei einem Sequentialisierungselement 130, 132 ist zu einem bestimmten Zeitpunkt der eine Ausgang 136 immer mit einem Eingang der Eingänge 134 verbunden. Das Umschalten zwischen den einzelnen Eingängen 134 erfolgt durch einen externen Trigger 138, 140. Der externe Trigger 138, 140 kann von der Auswerteeinheit gezielt bereitgestellt werden oder durch ein Taktsignal vorgegeben sein. Im letzteren Fall ist der Takt des Triggers 138 des zweiten Sequentialisierungselements 132 um einen Faktor größer als der Takt des Triggers 140 des ersten Sequentialisierungselements 130. Das Verhältnis ist so gewählt, dass das erste Sequentialisierungselement 130 einen ersten Eingang der Eingänge 134 mit dem Ausgang 136 verbindet, während das zweite Sequentialisierungselement in derselben Zeit alle Eingänge 134 einmal an den Ausgang 136 schaltet. So können auf einfache Weise nacheinander alle Sensorzellen 74 abgefragt werden, indem die jeweiligen Elektroden durch das erste und das zweite Sequentialisierungselement 130, 132 mit deren Ausgängen 136 verbunden werden.

Das erste und das zweite Sequentialisierungselement 130, 132 sind an ihren Eingängen 134 überbelegt, d.h. das erste Sequentialisierungselement 130 ist nicht nur mit den Elektroden 92, 94 der ersten Schicht 88, sondern auch mit den Elektroden 96 der zweiten Schicht 90 verbunden. Das zweite Sequentialisierungselement 132 ist nicht nur mit den Elektroden 96 der zweiten Schicht 90, sondern auch mit den Elektroden 92, 94 der ersten Schicht 90 verbunden. Wie in Fig. 7 dargestellt, können die Ausgänge 136 mit derselben Elektrode (hier die dritte Elektrode 96) verbunden sein. Mit anderen Worten werden bei einer derartigen Schalterstellung des ersten und zweiten Sequentialisierungselements 130, 132 die Sensorzellen 74 "überbrückt". Es besteht somit eine direkte Verbindung zwischen den Ausgängen 136 des ersten Sequentialisierungselements 130 und des zweiten Sequentialisierungselements 132.

Dieser "Kurzschluss" kann messtechnisch von einer an den ersten und zweiten Anschlüssen 126, 128 angeschlossenen Auswerteeinheit bestimmt werden. Schalten das erste und das zweite Sequentialisierungselement 130, 132 ordnungsgemäß, kann die Auswerteeinheit den entsprechenden Kurzschluss zwischen dem ersten Anschluss 126 und dem zweiten Anschluss 128 bestimmen. Für einen Selbsttest der Sequentialisierungselemente 130, 132 werden diese in Intervallen kurzgeschlossen und der Kurzschluss von der Auswerteeinheit abgefragt. Auf diese Weise können die Sequentialisierungselemente 130, 132 als Teil der Signalverarbeitungskette des Signalgebers kontinuierlich auf ihre Funktionsfähigkeit hin überprüft werden.

Fig. 8 zeigt ein besonders bevorzugtes Ausführungsbeispiel zur Kontaktierung eines matrixartigen Sensors 66. In dem Ausführungsbeispiel gemäß Fig. 8 sind neun Sensorzellen 74 über ein erstes Sequentialisierungselement 130 und ein zweites Sequentialisierungselement 132 mit einer Auswerteeinheit 46 verbunden. Die Schaltungsanordnung 125 weist neben der ersten, zweiten und dritten Elektrode 92, 94, 96 drei weitere Elektroden 142, 144, 146 auf, die die weiteren Sensorzellen 74 kontaktieren. Wie im Ausführungsbeispiel zuvor sind alle Elektroden 92, 94, 96, 142, 144, 146 je mit den Eingängen134 des ersten Sequentialisierungselements 130 und des zweiten Sequentialisierungselements 132 verbunden. So können nicht nur jeweils die zwei Elektroden einer Sensorzelle 74 mit den Ausgängen 136 verbunden werden, sondern auch direkte Verbindungen in zuvor erwähnter Weise erzeugt werden.

Im Ausführungsbeispiel gemäß Fig. 8 ist der Ausgang 136 des zweiten Sequentialisierungselements 132 über einen ersten Widerstand 148 mit einem elektrischen Masseanschluss 150 verbunden. Der Ausgang 136 des ersten Sequentialisierungselements 130 ist einerseits über einen zweiten Widerstand 152 mit einer Spannungsquelle 154 verbunden und andererseits ist der Ausgang 136 des ersten Sequentialisierungselements 130 mit einem Analog-Digital-Wandler (ADC) 156 der Auswerteeinheit 46 verbunden. Somit entsteht ein Spannungsteiler zwischen dem zweiten Widerstand 152 und dem ersten Widerstand 148 bzw. ein Spannungsteiler zwischen dem zweiten Widerstand 152 und der Summe aus dem zweiten Widerstand 152 und dem Widerstand 129der Sensorzelle 74, auf die das erste und das zweite Sequentialisierungselement 130, 132 geschaltet sind. Mit anderen Worten, wenn das erste Sequentialisierungselement 130 und das zweite Sequentialisierungselement 132 "kurzgeschlossen" sind, stellt sich am Analog-Digital-Konverter 156 eine definierte Spannung ein, die sich aus dem Spannungsteiler des ersten und zweiten Widerstands 148, 152 und der Spannung der Spannungsquelle 154 ergibt. Andererseits lässt sich der spezifische Widerstand 129einer Sensorzelle 74 einfach durch die Abweichung von diesem Erwartungswert bestimmen.

Auf diese Weise ist es besonders einfach möglich, mittels der Auswerteeinheit 46 den aktuellen Widerstand einer Sensorzelle 74 und damit die entsprechende Druckbelastung einer Sensorzelle 74 zu bestimmen. Ferner können die Sequentialisierungselemente 130, 132 auf einfache Weise hinsichtlich ihrer Adressierung überprüft werden. Zusätzliche Einrichtungen zur Überwachung der Sequentialisierungselemente 130, 132 sind nicht notwendig.

Darüber hinaus kann auch der Analog-Digital-Wandler 156 auf seinen ordnungsgemäßen Betrieb hin überprüft werden, wenn der erste Widerstand 148 und der zweite Widerstand 152 jeweils variabel einstellbar sind. Durch den variablen Spannungsteiler, der vorliegt wenn das erste und das zweite Sequentialisierungselement 130, 132 auf dieselbe Elektrode geschaltet sind, kann der gesamte Bereich des Analog-Digital-Wandlers 156 überprüfbar gemacht werden. Die Auswertung der Sensorzellen 74 sowie die Überwachung der Sequentialisierungselemente und/oder des Analog-Digital-Wandlers 156 können über einen Anschluss 158 einer übergeordneten Steuereinheit zur weiteren Verarbeitung übergeben werden.

In einem Ausführungsbeispiel ist die Auswerteeinheit 46 als OSSD ausgebildet, d.h. das Ausgangssignal am Ausgang 158 ist ein OSSD-Signal, welches einen ersten Zustand und einen zweiten Zustand anzeigen kann. Vorzugsweise handelt es sich um ein redundantes Taktsignal, mit zwei Komponenten, die nicht synchron zueinander sind. Der erste Zustand zeigt einen sicheren Zustand des Signalgebers an, d. h. einen Zustand, in dem weder eine Sensorzelle 74 belastet ist noch ein Fehler bei den Sequentialisierungselementen 130, 132 oder dem Analog-Digital-Wandler 156 erkannt worden ist. Der erste Zustand wird aktiv signalisiert, d. h. in diesem Zustand muss das redundante Signal anliegen. Der zweite Zustand wird durch das Ausbleiben des redundanten Taktsignals signalisiert und gibt an, dass entweder eine Sensorzelle 74 belastet worden ist oder ein Fehler bei den Sequentialisierungselementen 130, 132 oder des Analog-Digital-Wandlers 156 vorliegt.

In einem anderen Ausführungsbeispiel ist das Ausgangssignal der Auswerteeinheit 46 ein kodiertes Signal, welches Informationen beinhaltet, welche Sensorzelle 74 belastet bzw. unbelastet ist. Ebenso können die Ergebnisse der Selbsttests der Sequentialisierungselemente 130, 132 und des Analog-Digital-Wandlers 156 an ein Sicherheitssystem übertragen werden, so dass einerseits eine gezielte Auswertung der Berührung des Sensors 66 erfolgen kann und andererseits eine Diagnosemeldung generiert werden kann, die auf die Funktionsfähigkeit des Sensors 66 und dessen Signalverarbeitung hindeutet.

Vorstellbar sind auch Zwischenformen zwischen den letzten beiden Ausführungsbeispielen, beispielsweise indem von der Auswerteeinheit ein OSSD-Signal bereitgestellt wird und gleichzeitig über einen zweiten Ausgang die Diagnosedaten bereitgestellt werden. Es versteht sich, dass das Ausführungsbeispiel gemäß Fig. 8 auf eine beliebige Zahl von Sensorzellen 74 ausgedehnt werden kann und die Erfindung nicht auf die gezeigten neun Sensorzellen beschränkt ist.

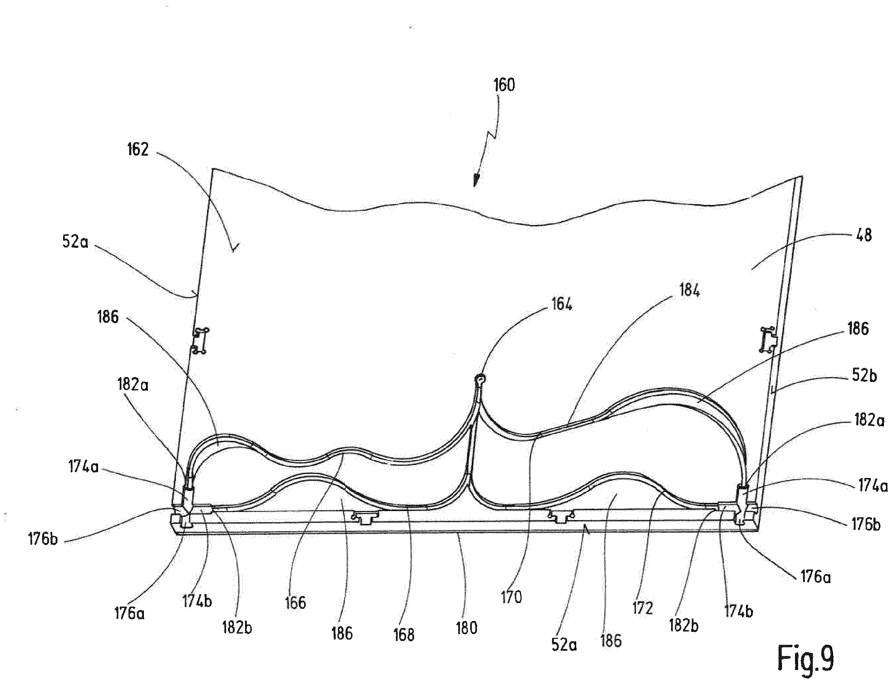

Fig. 9 zeigt ein bevorzugtes Ausführungsbeispiel einer Unterseite einer neuen Trittmatte in einer perspektivischen Darstellung. Die Unterseite 160 der Trittmatte entspricht der Unterseite des Trägerkörpers 48. Im Wesentlichen weist die Unterseite 160 eine ebene Oberfläche 162 auf, in die Strukturen eingearbeitet sind, um eine Kontaktierung der im Trägerkörper 48 innenliegenden Elektronik zu ermöglichen. Die Strukturen werden beispielsweise durch einen Oberflächenfräsvorgang in die ebene Oberfläche 162 eingearbeitet oder unmittelbar beim Herstellen des Trägerkörpers 48, bspw. beim Spritzgießen, gebildet.

Im Ausführungsbeispiel gemäß Fig. 9 weisen die Strukturen eine Durchgangsöffnung 164, eine erste, zweite, dritte und vierte Kabelführung 166, 168, 170, 172 sowie Fassungen 174a, 174b in Form von Senken in der Unterseite 160 auf. Die Durchgangsöffnung 164 ist eine zur ebenen Oberfläche 162 senkrechte Öffnung, vorzugsweise in Form einer Bohrung, die sich durch den Trägerkörper 48 erstreckt. Durch die Durchgangsöffnung 164 kann eine Verbindung zu einer innerhalb des Trägerkörpers 48 liegenden Elektronik, wie beispielsweise die Auswerteeinheit der Trittmatte, hergestellt werden. In einem bevorzugten Ausführungsbeispiel ist durch die Durchgangsöffnung 164 ein hier nicht dargestelltes Kabel geführt. Das Kabel ist vorzugweise ein mehradriges Kabel mit einer schützenden Ummantelung. Alternativ ist auch die Verwendung eines vorkonfektionierten Kabelbaums denkbar.

Das Kabel ist vorzugsweise in der Durchgangsöffnung 164 fixiert und die Durchgangsöffnung 164 im Übrigen durch eine Dichtung oder Füllung staub- und wasserdicht versiegelt, sodass eine hohe Schutzart, beispielsweise IP67, gewährleistet werden kann. Durch die Fixierung weist der Teil des Kabels, der aus der Durchgangsöffnung 164 aus dem Trägerköper 48 heraustritt, eine definierte, feste Länge auf, an dessen Ende ein Steckverbinder angeordnet ist. Der Steckverbinder ist vorzugweise ein mehrpoliger Rundsteckverbinder in M5, M8 oder M12. In einem bevorzugten Ausführungsbeispiel weist der Steckverbinder eine Schraubverriegelung nach DIN EN 61076-2-104 oder Schnappverriegelung auf. Der Steckverbinder kann eine Schutzart IP65/IP67 aufweisen, bspw. indem der Steckverbinder am Kabel umspritzt ist. Besonders bevorzugt ist der Steckverbinder in einem 360° EMV-sicher geschirmt Metallgehäuse angeordnet, um eine hohe Zuverlässigkeit eine Signalübertragung zu gewährleisten.

Die Fassungen 174a, 174b bilden Aufnahmen für die Steckverbinder. Die Form einer Fassung 174a, 174b ist der Form eines Steckverbinders angepasst. Vorzugsweise ist eine Fassung 174a, 174b eine längliche Senke mit einem halbrunden Querschnitt, in die ein Rundsteckverbinder einclipsbar ist, sodass der Steckverbinder in der Senke gehalten wird. Die Fassungen 174a, 174b münden auf einer Seite in einer Aussparung 176a, 176b in den Seitenflächen 52a, 52b und gehen auf der gegenüberliegenden Seite in eine der Kabelführungen 166, 168, 170, 172 über. Besonders bevorzugt sind jeweils zwei Fassungen 174a, 174b kreuzförmig zueinander in einem Eckbereich, in dem die erste und zweite Seitenflächen 52a, 52b aneinander treffen, angeordnet. Vorzugweise sind die Abstände, in denen die Aussparungen 176a, 176b der beiden Fassungen 174a, 174b von der Stoßkante 178 der beiden Seitenflächen 52a, 52b entfernt sind, gleich groß, sodass sich die Aussparungen 176a, 176b zweier benachbarter Trittmatten gegenüberliegen, wenn die Trittmatten bündig aneinander stoßen. In einem bevorzugten Ausführungsbeispiel mit einem quaderförmigen Trägerkörper sind in allen vier Ecken sich überschneidende Fassungen angeordnet mit Aussparungen jeweils in einem festen Abstand zu den Seitenkanten des quaderförmigen Trägerkörper. Damit lassen sich die Trittmatten besonders flexibel miteinander kombinieren und zu einem Verbund zusammenfügen.

Die Fassungen 174a, 174b sind über Kabelführungen 166, 168, 170, 172 mit der Durchgangsöffnung 164 verbunden. Im Ausführungsbeispiel nach Fig. 9 ist die Durchgangsöffnung 164 bezogen auf eine Stirnseite 180 der Trittmatte mittig angeordnet. Zwei Fassungen 174a sind hier mit einer ersten Orientierung angeordnet, in der die Aussparungen 176a der Fassungen 174a in den Seitenflächen 52a liegen, wobei zwei weitere Fassungen 174b in einer zweiten Orientierung angeordnet sind, sodass deren Aussparungen 176b in den Seitenflächen 52b liegen. Vorzugsweise stehen die erste und zweite Orientierung in einem 90° Winkel zueinander, wenn der Trägerkörper 48 rechtwinklig ist. Die Übergänge 182a, 182b von den Fassungen 174a, 174b in die Kabelführungen 166, 168, 170, 172 sind in einem ersten und einem zweiten Abstand zur Durchgangsöffnung 164 angeordnet, wobei der erste Abstand und der zweite Abstand unterschiedlich groß sind. An den Übergängen 182a, 182b ist eine Kante ausgebildet, sodass ein in die Fassungen 174a, 174b eingelegter Steckverbinder nicht in die Kabelführungen gleiten kann.

In die Kabelführungen 166, 168, 170, 172 ist ein aus der Durchgangsöffnung 164 austretendes Kabel einlegebar. Die Kabelführungen 166, 168, 170, 172 bilden Kanäle in der ebenen Oberfläche 162, die von der Durchgangsöffnung 164 bis zu den Übergängen 182a, 182b verlaufen. Die Kanalwände sind abgerundet, wobei die Rundung so ausgebildet ist, dass eine Oberfläche des Kabels zumindest teilweise bündig an den Kanalwänden anliegt. Die Tiefe der Kanäle ist so ausgebildet, dass ein Kabel in den Kanälen vollständig hineingelegt werden kann und somit nicht aus der ebenen Oberfläche 162 hervorsteht. Vorzugsweise weisen die Kanäle im Querschnitt ein tonnenförmiges Profil auf. In einem anderen Ausführungsbeispiel ist das Profil U-förmig, wobei die unteren Ecken abgerundet sind.

Die Kanäle weisen in einem Ausführungsbeispiel eine Länge auf, die der definierten Länge des aus der Durchgangsöffnung 164 austretenden Kabels entspricht. Die Kanäle der einzelnen Kabelführungen 166, 168, 170, 172 sind vorzugsweise gleich lang. Der Verlauf der Kabelführungen 166, 168, 170, 172 ist kurvenförmig mit großen Krümmungsradien und weist keine Ecken auf. Der Verlauf ist knickfrei. Vorzugsweise sind die Radien größer als 10 cm. Im Ausführungsbeispiel gemäß Fig. 9 ist der kurvenförmige Verlauf einer Kabelführung 166, 168, 170, 172 aus verschiedenen Abschnitten zusammengesetzt. Die Abschnitte können gerade oder bogenförmige Abschnitte sein. Vorzugsweise sind zwischen den Abschnitten Übergangsbögen angeordnet, die so ausgebildet sind, dass beim Übergang von einem geraden Abschnitt in einen kreisbogenförmigen Abschnitt die Kurve nur langsam und nicht sprungartig enger wird. Der kurvenförmige Verlauf ermöglicht es, dass auch steife Kabel mit einer geringen Flexibilität gleichmäßig in die Kabelführungen eingelegt und somit sicher verstaut werden können. Insbesondere wird die Gefahr, dass beim Knicken der Kabel eine Ader bricht oder mehrere Adern bis zu einem Querschluss zusammengequetscht werden, verringert.

In einem Ausführungsbeispiel ist das Kabel ohne Spiel in den Kabelführungen 166, 168, 170, 172 verlegt. In einem anderen bevorzugten Ausführungsbeispiel weisen die Kanäle mindestens einen ersten Abschnitt 184 und einen zweiten Abschnitt 186 auf. Im ersten Abschnitt 184 ist ein Kabel ohne Spiel verlegbar. Im zweiten Abschnitt 186 wird ein Stauchraum gebildet, indem sich die Kabelführung in diesem Bereich weitet. Vorzugsweise nimmt die definierte Breite der Kabelführungen in einem ersten Bereich des zweiten Abschnitts 186 gleichmäßig zu und in einem anschließenden zweiten Bereich kontinuierlich wieder ab bis hin zu der definierten Breite des ersten Abschnitts 184. Der Stauchraum 186 ist dazu ausgebildet, ein Kabel spielfrei zu verlegen, um geringfügige Variationen in der Kabellänge auszugleichen. Die Kombination von Abschnitten mit Stauchräumen 186 und Abschnitten 184 mit passgenauer Kabelführung ermöglichen eine gute Fixierung des Kabels in den Kanälen, wobei gleichzeitig eine gewisse Flexibilität hinsichtlich der Kabellänge durch die Stauchräume 184 gegeben ist.

Die Flexibilität bei der Kabelführung ist von Bedeutung, wenn in einem Ausführungsbeispiel die Fassungen 174a, 174b weitere Strukturen zum Fixieren der Steckverbinder in unterschiedlichen Positionen aufweisen. So ist es denkbar, dass der Steckverbinder innerhalb der Fassung 174a, 174b in einer ersten und einer zweiten Position angeordnet werden kann, wobei in der ersten Position der Steckverbinder mit der Seitenfläche 52 bündig abschließt und in der zweiten Position der Steckverbinder über die Seitenfläche 52 hinausgeht bzw. weiter im Inneren des Trägerkörper 48 zum Liegen kommt und somit nicht bündig mit den Seitenflächen abschließt. In der zweiten Position muss das Kabel zum Steckverbinder länger bzw. kürzer sein, als in der ersten Position. Diese Variation der Länge kann durch die Stauchräume 186 erreicht werden.

Es versteht sich, dass die Ausgestaltung der Unterseite nicht auf die hier gezeigten Ausführungsbeispiele beschränkt ist. Insbesondere kann in anderen Ausführungsbeispielen die Durchgangsöffnung 164 auch außermittig angeordnet sein. Ebenso können weitere Durchgangsöffnungen mit weiteren Kabelführungen sowie Durchgangsöffnungen mit mehreren Kabeln vorgesehen sein, um auch die weiteren Seitenflächen mit Anschlussmöglichkeiten zu versehen. In einem bevorzugt Ausführungsbeispiel wird über eine erste Durchgangsöffnung 164 ein Ausgangssignal der Auswerteeinheit der Trittmatte bereitgestellt und über eine weitere Durchgangsöffnung ein Eingangs- oder Steuersignal aufgenommen. Besonders bevorzugt lassen sich Signale von einer Durchgangsöffnung über die Auswerteeinheit zu einer weiteren Durchgangsöffnung durchschleifen. Damit lässt sich besonders gut ein in Serie geschalteter Verbund von Trittmatten bilden.

## Patentansprüche

1. Trittmatte (10) zum Absichern einer technischen Anlage (14),
mit einem Sensor (66), einem starren Trägerkörper (48) und einer Auswerteeinheit (46),
wobei der Sensor (66) eine aktive Sensorfläche (44) und einen flexiblen Anschlussbereich (70) zur elektrischen Kontaktierung der Sensorfläche aufweist, der an einem Rand der aktiven Sensorfläche (44) ausgebildet ist,
wobei der Trägerkörper (48) eine Basis (114) mit einer Oberseite (50) und eine daran anschließende erste Seitenfläche (52) aufweist,
wobei die Auswerteeinheit (46) dazu ausgebildet ist, ein Ausgangssignal in Abhängigkeit der Betätigung der aktiven Sensorfläche (44) zu erzeugen, **dadurch gekennzeichnet, dass** die Auswerteeinheit (46) im inneren des Tragekörpers unterhalb der aktiven Sensorfläche (44) angeordnet ist, und
die aktive Sensorfläche (44) die Oberseite (50) der Basis (114) des Trägerkörpers (48) vollständig bedeckt, und
der Anschlussbereich (70) des Sensors (66) an der ersten Seitenfläche (52) um 180° umgelegt und ins Innere des Trägerkörpers (48) geführt ist.

2. Trittmatte nach Anspruch 1, wobei im Anschlussbereich (70) Aussparungen (84) vorgesehen sind und die erste Seitenfläche (52) ein Profil mit nutenartigen Ausnahmen aufweist, wobei die Aussparungen (84) in das Profil eingreifen, wenn der Anschlussbereich (70) um die erste Seitenfläche (52) gelegt ist.

3. Trittmatte nach einem der Ansprüche 1 oder 2, wobei die aktive Sensorfläche (44) aus einem flexiblen Material gefertigt ist und der Anschlussbereich (70) eine Verlängerung der aktiven Sensorfläche (44) aus demselben Material ist.

4. Trittmatte nach einem der Ansprüche 1 bis 3, wobei der Sensor (66) eine erste Schicht (88) mit Elektroden (92, 94) in einer ersten Orientierung, eine zweite Schicht (90) mit Elektroden (96) in einer zweiten Orientierung, sowie eine zwischen der ersten und zweiten Schicht liegende dritte Schicht (100) aufweist.

5. Trittmatte nach Anspruch 4, wobei die erste und zweite Schicht (88, 90) je ein flexibles Gewebe sind, in das die Elektroden (92, 94, 96) mit leitfähigem Garn eingewebt sind.

6. Trittmatte nach einem der Ansprüche 4 bis 5 wobei die dritte Schicht (100) aus flexiblen, leitfähigen Material gebildet ist, welches bei lokaler Belastung seinen spezifischen elektrischen Widerstand im Ort der Belastung ändert.

7. Trittmatte nach einem der Ansprüche 4 bis 6, wobei der Anschlussbereich (70) in einen ersten und zweiten Bereich unterteilt ist und die Basis (114) eine weitere Seitenfläche aufweist, wobei der erste Bereich um die erste Seitenfläche (52) umgelegt ist und der zweite Bereich um die weitere Seitenfläche umgelegt ist.

8. Trittmatte nach Anspruch 7, wobei die Elektroden (92, 94) der ersten Schicht (88) in den ersten Bereich verlängert sind und die Elektroden (96) der zweiten Schicht (90) in den zweiten Bereich verlängert sind.

9. Trittmatte nach einem der Ansprüche 4 bis 6, wobei der Anschlussbereich (70) nur an einer Seite der aktiven Sensorfläche (44) ausgebildet ist, und die Elektroden (92, 94, 96) der ersten Schicht und der zweiten Schicht in den Anschlussbereich geführt sind.

10. Trittmatte nach Anspruch 9, wobei die erste Schicht (88) Zwischenbereiche (98), die die Elektroden (92, 94) voneinander beabstanden, und weitere Leiterbahnen (102) mit der ersten Orientierung aufweist, die in den Zwischenbereichen (98) angeordnet sind und die Elektroden (96) der zweiten Schicht (90) kontaktieren, wobei die Elektroden (92, 94) der ersten Schicht und die weiteren Leiterbahnen (102) in den Anschlussbereich (70) geführt sind.

11. Trittmatte nach einem der Ansprüche 1 bis 10, wobei die aktive Sensorfläche (44) größer als 0,25 m², vorzugsweise zwischen 0,25 m² und 1 m², ist.

12. Trittmatte nach einem der Ansprüche 1 bis 11, wobei der Anschlussbereich (70) mit einem Umlenkradius von 0,5 cm bis 1 cm um die erste Seitenfläche (52) umgelegt ist.

13. Trittmatte nach einem der Ansprüche 1 bis 12, wobei die Trittmatte ferner eine Abdeckplatte (112) aufweist, auf dem die aktive Sensorfläche (44) angeordnet ist, wobei die Abdeckplatte (112) lösbar auf dem Trägerkörper (48) angeordnet ist, um einen Zugang zu der Auswerteeinheit (46) zu ermöglichen.

## Claims

1. Safety mat (10) for safeguarding a technical installation (14), comprising a sensor (66), a rigid supporting body (48) and an evaluation unit (46),
wherein the sensor (66) has an active sensor area (44) and a flexible connection region (70) for contacting the sensor area, the flexible connection region being formed at a border of the active sensor area,
wherein the supporting body (48) has a base (114) with a top side (50) and an adjoining first side face (52) thereto,
wherein the evaluation unit (46) is configured to generate an output signal depending on the actuation of the active sensor area (44),
**characterized in that** the evaluation unit (46) is arranged in the interior of the supporting body below the active sensor area (44), and the active sensor area (44) completely covers the top side (50) of the base (114) of the supporting body (48), and
the connection region (70) of the sensor (66) is folded around the first side face (52) through 180° and guided into the interior of the supporting body (48).

2. Safety mat according to claim 1, wherein cavities (84) are provided in the connection region (70), and the first side face (52) has a profile with groove-like cavities,
wherein the cavities (84) engage in the profile when the connection region (70) is folded around the first side face (52).

3. Safety mat according to any one of claims 1 or 2, wherein the active sensor area (44) is produced from a flexible material, and the connection region (70) is an extension of the active sensor area (44) of the same material.

4. Safety mat according to any one of claims 1 to 4, wherein the sensor (66) has a first layer (88) with electrodes (92, 94) in a first orientation, a second layer (90) with electrodes (96) in a second orientation, and a third layer (100) which is situated between the first and the second layer.

5. Safety mat according to claim 4, wherein the first and the second layer (88, 90) are each a flexible woven fabric into which the electrodes (92, 94, 96) are woven with conductive yarn.

6. Safety mat according to any one of claims 4 to 5, wherein the third layer (100) is formed from flexible, conductive material which, under local loading, changes its specific electrical resistance at the site of the loading.

7. Safety mat according to any one of claims 4 to 6, wherein the connection region (70) is subdivided into a first and a second region, and the base (114) has a further side face,
wherein the first region is folded around the first side face, and the second region is folded around the further side face.

8. Safety mat according to claim 7, wherein the electrodes (92, 94) of the first layer (88) are extended into the first region, and the electrodes (96) of the second layer (90) are extended into the second region.

9. Safety mat according to any one of claims 4 to 6, wherein the connection region (70) is formed only on one side of the active sensor area (44), and the electrodes (92, 94, 96) of the first layer and of the second layer are guided into the connection region (70).

10. Safety mat according to claim 9, wherein the first layer (88) has intermediate regions (98), which space apart the electrodes (92, 94) from one another, and further conductive paths (102) with the first orientation which are arranged in the intermediate regions (98) and which contact the electrodes (96) of the second layer,
wherein the electrodes (92, 94) of the first layer and the further conductive paths (102) are guided into the connection region (70).

11. Safety mat according to any one of claims 1 to 10, wherein the active sensor area (44) is larger than 0.25 m², preferably between 0.25 m² and 1 m².

12. Safety mat according to any one of claims 1 to 11, wherein the connection region (70) is folded around the first side face (52) with a deflection radius of from 0.5 cm to 1 cm.

13. Safety mat according to any one of claims 1 to 12, wherein the safety mat further has a cover plate (112) on which the active sensor area (44) is arranged,
wherein the cover plate (112) is arranged on the supporting body (48) in a releasable manner, in order to allow access to the evaluation unit (46).

## Revendications

1. Tapis sensible (10), destiné à sécuriser un équipement (14), le tapis sensible comprenant
un capteur (66), un corps porteur rigide (48) et une unité d'interprétation (46),
le capteur (66) ayant une surface de capteur active (44) et une région de connexion flexible (70) qui est destinée à venir en contact électrique avec la surface de capteur et qui est formée au niveau d'un bord de la surface de capteur active (44),
le corps porteur (48) comportant une base (114) pourvue d'un surface supérieure (50) et d'une première surface latérale (52) adjacente à celle-ci,
l'unité d'interprétation (46) étant conçue pour générer un signal de sortie en fonction de l'actionnement de la surface de détection active (44),
**caractérisé en ce que** l'unité d'interprétation (46) est disposée à l'intérieur du corps porteur au-dessous de la surface de détection active (44), et
la surface de capteur active (44) recouvre complètement le côté supérieur (50) de la base (114) du corps porteur (48), et
la région de raccordement (70) du capteur (66) à la première surface latérale (52) est repliée à 180° et guidée jusque dans le corps porteur (48).

2. Tapis sensible selon la revendication 1, des évidements (84) étant ménagés dans la région de raccordement (70) et la première surface latérale (52) ayant un profil pourvu de logement de type gorges, les évidements (84) s'engageant dans le profil lorsque la région de raccordement (70) est placée autour de la première surface latérale (52).

3. Tapis sensible selon la revendication 1 ou 2, la surface de capteur active (44) étant réalisée à partir d'un matériau flexible et la région de raccordement (70) étant une extension de la surface de capteur active (44) du même matériau.

4. Tapis sensible selon l'une des revendications 1 à 3, le capteur (66) comprenant une première couche (88) pourvue d'électrodes (92, 94) dans une première orientation, une deuxième couche (90) pourvue d'électrodes (96) dans une deuxième orientation et une troisième couche (100) située entre les première et deuxième couches.

5. Tapis sensible selon la revendication 4, les première et deuxième couches (88, 90) étant chacune un tissu flexible dans lequel les électrodes (92, 94, 96) sont tissées avec un fil conducteur.

6. Tapis sensible selon l'une des revendications 4 à 5, la troisième couche (100) étant en un matériau conducteur flexible qui voit, en cas de contrainte locale, sa résistance électrique spécifique varier à l'emplacement de la contrainte locale.

7. Tapis sensible selon l'une des revendications 4 à 6, la région de raccordement (70) étant divisée en une première et une deuxième région et la base (114) ayant une autre surface latérale, la première région étant repliée autour de la première surface latérale (52) et la deuxième région étant repliée autour de l'autre surface latérale.

8. Tapis sensible selon la revendication 7, les électrodes (92, 94) de la première couche (88) s'étendant dans la première région et les électrodes (96) de la deuxième couche (90) s'étendant dans la deuxième région.

9. Tapis sensible selon l'une quelconque des revendications 4 à 6, la région de raccordement (70) étant formée sur un seul côté de la surface de capteur active (44), et les électrodes (92, 94, 96) de la première couche et de la seconde couche étant guidées dans la région de raccordement.

10. Tapis sensible selon la revendication 9, la première couche (88) comportant des régions intermédiaires (98) espaçant les électrodes (92, 94) les unes des autres et d'autres pistes conductrices (102) ayant la première orientation, lesquelles sont disposées dans les régions intermédiaires (98) et viennent en contact avec les électrodes (96) de la deuxième couche (90), les électrodes (92, 94) de la première couche et les autres pistes conductrices (102) étant guidées jusque dans la région de raccordement (70).

11. Tapis sensible selon l'une des revendications 1 à 10, la surface de capteur active (44) étant supérieure à 0,25 m², de préférence comprise entre 0,25 m² et 1 m².

12. Tapis sensible selon l'une des revendications 1 à 11, la région de raccordement (70) étant repliée autour de la première surface latérale (52) avec un rayon de retournement de 0,5 cm à 1 cm.

13. Tapis sensible selon l'une des revendications 1 à 12, le tapis sensible comprenant en outre une plaque de recouvrement (112) sur laquelle est disposée la surface de capteur active (44), la plaque de recouvrement (112) étant disposée de manière amovible sur le corps porteur (48) pour permettre l'accès à l'unité d'interprétation (46).
